(19) **Europäisches Patentamt / European Patent Office / Office européen des brevets**

(11) **EP 2 356 704 B1**

(12) **EUROPÄISCHE PATENTSCHRIFT**

(45) Veröffentlichungstag und Bekanntmachung des Hinweises auf die Patenterteilung:
**27.03.2013 Patentblatt 2013/13**

(21) Anmeldenummer: **09774808.1**

(22) Anmeldetag: **11.11.2009**

(51) Int Cl.:
**H01L 35/32** (2006.01)  **H01L 35/08** (2006.01)

(86) Internationale Anmeldenummer:
**PCT/AT2009/000428**

(87) Internationale Veröffentlichungsnummer:
**WO 2010/063044 (10.06.2010 Gazette 2010/23)**

(54) **VERFAHREN ZUR UMWANDLUNG VON WÄRMEENERGIE IN ELEKTRISCHE ENERGIE**

METHOD FOR CONVERTING THERMAL ENERGY INTO ELECTRIC ENERGY

PROCÉDÉ DE TRANSFORMATION D'ÉNERGIE THERMIQUE EN ÉNERGIE ÉLECTRIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **14.11.2008 AT 17742008**

(43) Veröffentlichungstag der Anmeldung:
**17.08.2011 Patentblatt 2011/33**

(73) Patentinhaber:
• **Fuchs, Herbert Karl**
  **4810 Gmunden (AT)**
• **Köbrunner, Reinhold**
  **4840 Vöcklabruck (AT)**

(72) Erfinder:
• **Fuchs, Herbert Karl**
  **4810 Gmunden (AT)**

• **Köbrunner, Reinhold**
  **4840 Vöcklabruck (AT)**

(74) Vertreter: **Jell, Friedrich**
  **Patentanwaltskanzlei Jell**
  **Bismarckstrasse 9**
  **4020 Linz (AT)**

(56) Entgegenhaltungen:
WO-A1-94/28364          WO-A2-2006/085179
JP-A- 3 155 376         JP-A- 5 226 704
JP-A- 5 299 704         JP-A- 9 214 005
US-A- 3 392 061         US-A- 5 712 448
US-A1- 2002 033 189     US-A1- 2004 018 729
US-A1- 2006 107 986

**EP 2 356 704 B1**

**Beschreibung**

Die Erfindung betrifft ein Verfahren zur Umwandlung von Wärmeenergie in elektrische Energie mit einem Thermoelement entsprechend dem Oberbegriff des Anspruchs 1.

Die Umwandlung von Wärmeenergie in elektrische Energie erfolgt bei der vorliegenden Erfindung unter Anwendung thermoelektrischer Effekte, insbesondere des Seebeck- und des Peltier Effektes und wobei diese Effekte durch das Vorhandensein einer TemperaturDifferenz hervorgerufen werden (Seebeck-Effekt), oder umgekehrt eine TemperaturDifferenz erzeugen (Peltier-Effekt).

Konventionelle thermoelektrische Energieerzeugung (siehe zum Beispiel JP03155376) nutzt die als Seebeck-Effekt bekannte Erscheinung aus, dass zwischen zwei unterschiedlichen, elektrisch leitenden Materialien, welche beide jeweils unterschiedliche elektrische und thermische Leitfähigkeit besitzen und zumindest an einem ihrer Enden elektrisch leitend miteinander verbunden sind, eine Potentialdifferenz, respektive elektrische Spannung erzeugt wird, wenn zwischen den miteinander verbundenen Enden und den gegenüberliegenden Enden ein Temperaturgradient vorliegt. Die beiden unterschiedlichen Materialien sind dabei elektrisch in Serie, thermisch aber parallel verbunden. Die elektrische Reihenschaltung und thermische Parallelschaltung einer Vielzahl solcher Thermoelemente ergibt einen Thermoelektrischen Generator

("TEG") der dazu eingesetzt wird, aus einer Temperaturdifferenz, die zumeist aus einer Wärmequelle einerseits und einer kühlenden Vorrichtung andererseits erhalten wird, elektrische Energie zu gewinnen. Der Wirkungsgrad η berechnet sich bekanntlich als Quotient aus der elektrischen Leistung P und dem gesamten Wärmestrom Q.

$$\eta = \frac{P}{Q} \quad \text{bzw.} \quad \eta = \frac{\text{erhaltene elektrische Leistung}}{\text{zugeführte Wärmeenergie / Zeiteinheit}}$$

Der Nachteil aller gegenwärtig bekannten TEG's liegt darin, dass der Wirkungsgrad dieser Form der Energieumwandlung relativ gering ist (4 - 6 % für Halbleiter TEG's). Es besteht daher ein dringender Bedarf, diesen z.Zt. noch bescheidenen Wirkungsgrad deutlich zu verbessern und der Thermoelektrischen Energie-Erzeugung Anwendungsgebiete zu erschließen, die bisher den bekannten Kalorischen Maschinen und anderen Erzeugungsformen für elektrische Energie vorbehalten sind. Damit könnten die Anwendungsmöglichkeiten für umweltfreundliche und Ressourcen schonende Energieerzeugung unter Berücksichtigung der Kostenrelevanz signifikant erweitert werden.

Wärmeenergie kann auf die verschiedenartigste Weise leicht erzeugt werden und ist daher nicht notwendigerweise auf ganz bestimmte, zum Beispiel fossile Brennstoffe angewiesen. Sie steht auch außerdem aus einer Vielzahl von bisher nur selten genutzten, oder überhaupt vernachlässigten Wärmequellen zur Verfügung. Beispielsweise Abwärme aus Industrieprozessen, Abwärme aus Verbrennungskraft-Maschinen, Erdwärmequellen, Thermische Solarenergie usw. zur Verfügung.

Die Nutzung dieser Wärmequellen ist bisher hauptsächlich dadurch eingeschränkt, dass das dabei vorliegende Temperaturniveau bzw. die gegenüber der Umgebungstemperatur vorliegende Temperaturdifferenz, von seltenen Fällen ausgenommen, im Allgemeinen zu gering ist, um von konventionellen Wärmekraftmaschinen wie etwa Dampfmotor, Dampfturbine etc. verwertet werden zu können.

Ein thermoelektrischer Generator kann dieses brachliegende Energiepotential jederzeit nutzen und bietet hierzu noch den immensen Vorteil der einfachen Bauweise, des Fehlens von beweglichen Teilen und ist nahezu wartungsfrei. Der derzeit noch sehr geringe Wirkungsgrad von 4 - 6 % steht einer Kosten-Nutzen Relevanz aber bisher massiv entgegen.

Die Aufgabe der Erfindung ist es, ein Verfahren zur Umwandlung von Wärmeenergie in elektrische Energie mit einem Thermoelement zur Nutzung des thermoelektrischen Effekts zu schaffen, mit der es möglich ist, einen höheren Wirkungsgrad zu erreichen.

Die Aufgabe der Erfindung wird durch ein Verfahren gemäß den Merkmalen des Anspruchs 1 gelöst. Demgemäß ist ein Verfahren zur Umwandlung von Wärmeenergie in elektrische Energie mit zumindest einem Thermoelement zur Nutzung des thermoelektrischen Effekts vorgesehen, wobei das Thermoelement aus zwei elektrisch in Serie geschalteten Thermoschenkeln mit voneinander verschiedenen thermoelektrischen Koeffizienten gebildet ist und wobei die Thermoelemente jeweils über eine zu erwärmende Kontaktstelle verfügen. Dabei weist die zu erwärmende Kontaktstelle gegenüber den Thermoschenkeln eine Kontakt-Fläche auf, die kleiner ist als 5 % des Werts eines "Gemittelten Gesamt-Leitungsquerschnittes" der beiden Thermoschenkel.

Vorteilhaft ist dabei, dass damit der Wirkungsgrad für Thermoelektrische Energie-Erzeugung signifikant erhöht wird, indem die dem Thermogenerator per Zeiteinheit zugeführte Wärmemenge sich soweit wie möglich auf das Energieäquivalent der erzeugten elektrischen Leistung eingrenzt.

Erfindungsgemäß ist dafür ebenfalls vorgesehen, die vom TEG benötigte Wärme auf dem zur Verfügung stehenden, beziehungsweise anwendbarem Temperaturniveau direkt in die, erfindungsgemäß speziell ausgebildeten Kontakt-Grenzschichten der zu erwärmenden, aus unterschiedlichen Thermoelement-Materialien (A, B) bestehenden Verbindungsstellen der einzelnen, den Thermogenerator bildenden Thermoelemente, einzubringen. Weiters wird vermittels des im geschlossenen Stromkreis unmittelbar und gleichzeitig zum Seebeck-Effekt parallel auftretenden Peltier-Effektes die den speziell ausgebildeten heißen Kontaktflächen und nur dort zugeführte Wärme großteils sofort verbraucht und in elektrische Energie umgewandelt.

Damit bleibt für die als Verlust zu betrachtende Wärmeströmung entlang der die einzelnen Thermoelemente bildenden Thermoschenkel erheblich weniger übrig als bei derzeit bekannten Systemen.

Erfindungsgemäß wird also der hohe Wirkungsgrad dadurch erreicht, dass im Unterschied zu allen herkömmlichen Systemen die verlustreiche Wärmeströmung von den erhitzten zu den kalten Kontaktstellen nicht durch spezielle Materialeigenschaften möglichst behindert wird, sondern aus der an den speziellen Kontakt-Grenzschichten stattfindenden Energieumwandlung nur ein vergleichsweise geringer Überschuss an ungenutzter Wärmeenergie zurückbleibt der durch Wänneleitung abfließen kann.

Wie in dieser Schrift noch näher erläutert, wird ergänzend zu dem vorteilhaften Umwandlungsprozess, der restliche Wärmefluss entlang der Schenkel-Materialien auch noch durch zusätzliche Maßnahmen eingeschränkt. Erreicht wird dies dadurch, dass die Leitungsquerschnitte der die einzelnen Thermoelemente bildenden Schenkel-Materialien zueinander in einem exakt vorab definierten, optimalen Verhältnis zueinander stehen, ohne dass deshalb die ausgewählten oder zur Verfügung stehenden Gesamtabmessungen der Thermoelemente verändert werden müssen. Diese Querschnittsoptimierung bewirkt eine zusätzliche Erhöhung des Wirkungsgrades.

Die vorliegende Erfindung stellt eine Weiterentwicklung der bisherigen, mit dem Seebeck-Effekt arbeitenden Thermogeneratoren dar, die mit vergleichsweise billigen und hinreichend vorhandenen Konstruktions-Rohstoffen einen hohen Wirkungsgrad realisiert, der den Einsatz von Thermogeneratoren zwecks Energieerzeugung auch in jenen Bereichen ermöglicht, die dieser Art von Energieerzeugung wegen der unverhältnismäßig hohen Kosten und der vergleichsweise geringen Effizienz bisher verschlossen blieben.

Das erfindungsgemäße Verfahren ist in besonderer Weise dafür geeignet, vorhandene Ressourcen umweltschonend zu nutzen, insbesondere auch $CO_2$-neutrale Brennstoffe und bisher ungenutzte Wärmequellen zu verwenden und als autarke, dezentrale Energiequelle vielfältige Aufgaben durchzuführen.

Allgemeiner Uberblick betreffend den Stand der Technik:

Seit der Entdeckung Seebeck's (1821) fehlte es nicht an Versuchen, durch Zusammenschaltung einer entsprechenden Anzahl von Thermoelementen eine nutzbar hohe Spannung zu erzeugen und somit auf einfache Weise und ohne Umwege aus Wärme elektrische Energie zu erhalten.

In der zweiten Hälfte des 19. Jahrhunderts waren bereits verschiedenartige Geräte, damals nannte man sie "Thermosäulen" in Gebrauch, die die bis dato üblichen Säure BatterieElemente ersetzen konnten. Bekannt sind in diesem Zusammenhang die Thermosäulen von Nobile, Noe, Clamond, Markus, Gülcher, Raub und Cox. Die Thennosäulen von Raub und jene von Cox konnten trotz des bereits erkannten, extrem niedrigen Nutz-Wirkungsgrades von damals zumeist weniger als 1 % bereits soviel elektrische Energie erzeugen, dass sie gewerblich genutzt werden konnten. Mit der Erfindung der Dynamo-Maschine von Siemens, die ein Vielfaches an Spannung und Leistung erbringen konnte, gerieten die Thermosäulen Anfang des 20. Jahrhunderts in Vergessenheit.

Die Entdeckung der Halbleiter gegen die Mitte des 20. Jahrhunderts stellte allerdings neue Thermo-Materialien zur Verfügung, die weit höhere Seebeck-Spannungen und höhere Wirkungsgrade vorweisen konnten.

Eine Reihenschaltung von Thermoelementen aus p- und n-Halbleitermaterial bildet bis heute die Grundlage für Thermogeneratoren und Peltier Elemente.

Da aus technisch-physikalischer Sicht zwischen Peltier-Elementen und Thermoelementen kein Unterschied besteht, kann eine Reihenschaltung von Thermoelementen sowohl für die Energieerzeugung aus Wärme (Thermogenerator), als auch für Erwärmungs- oder Kühlsysteme grundsätzlich verwendet werden.

Der effektive Wirkungsgrad von Halbleiter-Thermoelementen ist wohl deutlich höher als jener der ursprünglichen Metall-Thermoelemente, konnte aber trotz intensiver Forschung für neue Materialien bis gegen Ende des 2. Jahrtausends nur in bescheidenem Maß verbessert werden. Gegenwärtig sind Thermogeneratoren aus Halbleitermaterial für zivile Anwendungen noch immer erst bei einem Wirkungsgrad von etwa 4 % - 6 %. Für militärische Anwendungen und die Raumfahrt liegt die Größenordnung derzeit bei etwa 7 % oder geringfügig darüber. Erst in den letzten Jahren wurde ein neuer Lösungsweg für bessere Effizienz eingeschlagen.

Um den Wirkungsgrad thermoelektrischer Energieumwandlung zu steigern, gibt es zwei grundsätzliche Lösungsansätze.

Einerseits der vom Anfang an und bis dato immer noch verfolgte Weg, Materialien zu erzeugen, die höhere Thermospannungen ergeben und dennoch brauchbare elektrische Leitfähigkeit aufweisen, ohne dass gleichzeitig die thermische Leitfähigkeit ebenfalls proportional erhöht wird. Der andere und erst in jüngster Zeit intensivierte Lösungsweg besteht darin, weniger auf einen hohen Seebeck-Koeffizienten Wert zu legen, sondern sich auf die Blockade der Wärmeleitfähigkeit zu konzentrieren, ohne dass dadurch auch eine proportionale Einbuße an elektrischer Leitfähigkeit auftritt.

Dieser letztgenannte neue Lösungsweg wird durch die derzeit favorisierte Methode der "Super Lattice Quantum Well" Technologie repräsentiert. "Quantum Well"-Technologie ist gegenwärtig imstande, Wirkungsgrade in der Größenordnung von etwa 11 % hervorzubringen und befindet sich zur Zeit im praktischen Erprobungsstadium.

Diese Technologie stützt sich dabei auf die physikalische Erscheinung, dass extrem dünne, nur wenige Nanometer dicke Schichten aus Halbleitermaterial in ihrer elektrischen Leitfähigkeit nur unwesentlich, in ihrer thermischen Leitfähigkeit aber erheblich behindert werden. Thermoelektrische Materialien die nach dieser Technologie gefertigt sind, weisen eine Struktur auf, die aus mehreren zehntausend parallelen und durch isolierende Zwischenlagen getrennten Schichten per Millimeter Dicke bestehen. Das Herstellungsverfahren hiefür ist extrem komplex und kostenaufwendig. Ein ebenfalls neuer, aber erst im Laborstadium befindlicher Lösungsweg besteht darin, die Effekte der "quantum well" Technologie mit HalbleiterMaterialien aus Nano-Partikeln zu erzielen.

Die weitaus größte Anzahl von Veröffentlichungen beschreibt Thermogeneratoren in konventioneller Halbleiter-Technik, bei denen der kennzeichnende Teil sich auf vorteilhafte, anwendungsorientierte Gestaltung des Gesamtapparates oder Teilen desselben bezieht, nicht jedoch auf eine Verbesserung des Wirkungsgrades der energieerzeugenden Halbleiter-Module. Andere Veröffentlichungsschriften wiederum beschreiben die Herstellung von Reihenschaltungen von konventionellen Halbleiter-Thermoelementen in Dünnschicht-Technik auf Trägermaterialien und gegebenenfalls deren Miniaturisierung. Schließlich sind auch Veröffentlichungen bekannt, die sich auf die Zusammensetzung und Herstellung verbesserten Halbleiter-Materials beziehen.

Die vorliegende Erfindung verfolgt ebenfalls die moderne Grundauffassung, den Wirkungsgrad dadurch zu erhöhen, dass die Verluste durch Wärmeleitung, die entlang der Thermoschenkel von den erwärmten Kontaktstellen in Richtung der kühl zu haltenden Kontaktstellen auftreten, soweit wie möglich einzugrenzen. Abweichend zum bekannten Stand der Technik wird hierbei jedoch nicht die Methode angewandt, mittels Materialtechnologien die grundsätzliche Wärmeleitfähigkeit der verwendeten thermoelektrischen Materialien zu reduzieren. Die vorliegende Erfindung stützt sich dabei auf die Tatsache, dass die aus einem Temperaturgradienten in Verbindung mit dem materialspezifischen, relativen Seebeck-Koeffizienten entstehende Thermospannung in voller Höhe auch dann erhalten wird, wenn zwischen den beiden Thermoschenkel-Materialien auch nur eine winzige, den Übergang bildende Kontaktstelle vorliegt, in der die für den Temperaturgradienten maßgebliche Temperatur vorhanden ist.

Thermische Verluste sind dennoch unvermeidlich und werden auch einkalkuliert. Die Größenordnung dieser unvermeidlichen Verluste erreicht aber nur einen Bruchteil jener, die bei den bisher bekannten Systemen auftreten.

Die Erfindung wird anhand der beiliegenden Zeichnungen und der Beschreibung erläutert. Es zeigen jeweils in stark schematisch vereinfachter Darstellung:

Fig. 1a     ein Standard-Thermoelement ohne Querschnittsoptimierung;

Fig. 1b     das Thermoelement mit Querschnittsoptimierung auf geringsten Widerstand;

Fig. 1c     das Thermoelement mit Querschnittsoptimierung auf geringsten thermischen Durchfluss;

Fig. 2a     das Grundbeispiel einer "punktuell" ausgerichteten, minimierten Kontaktzone;

Fig,2b     die Unteransicht der minimierten Kontaktbrücke;

Fig. 2c     das Thermoelement im Schnitt und die Wärmezuführung;

Fig. 2d     die Kontaktbrücke und deren Wärme-Abschirmung;

Fig. 3a     das Grundbeispiel einer "linear" ausgerichteten, minimierten Kontaktzone;

Fig. 3b     die Unteransicht der "linear" ausgerichteten Kontaktbrücke;

Fig. 3c     das Thermoelement im Schnitt und die Wärmezuführung;

Fig. 3d     die Kontaktbrücke und deren Wärmeabschirmung;

Fig. 4     die Wärmezuführung an zwei Thermoelemente vermittels eines profilierten Wärmeträgers;

Fig. 5     ein Thermoelement mit einer auf "linearen" Kontakt konzipierten "Thermozunge" und deren "Thermofuß";

Fig. 6a    ein Thermoelement in bevorzugter Bauform mit abgerundeten Schenkelprofilen und "Thermozunge" sowie "Thermofuß";

Fig. 6b    das Thermoelement im Schnitt und die Wärmezuführung;

Fig. 6c    zwei in Serie miteinander verbundene Thermoelemente bevorzugter Bauform im Schnitt und deren Wärmezuführung;

Fig. 7     einen nach den Erfindungsgrundlagen konzipierten Thermogenerator in zylinderförmiger Bauweise;

Fig. 8     den Ausschnitt eines nach den Erfindungsgrundlagen konzipierten Thermogenerators in ebener Bauausführung;

Fig. 9     ein alternatives Ausführungsbeispiel einer Thermoelementenanordnung mit einer annähernd keilförmigen Ausbildung der beiden Thermoschenkel A, B;

Fig. 10    ein weiteres Ausführungsbeispiel einer Thermoelementenanordnung aus zwei annähernd keilförmigen Thermoschenkeln A, B mit einer Wärmebrücke;

Fig. 11    ein Ausführungsbeispiel einer Thermoelementenanordnung in Dünnschichttechnik ausgeführt;

Fig. 12    ein Ausführungsbeispiel einer Thermoelementenanordnung mit einem pyramidenförmig ausgebildeten Paar von Thermoschenkeln A, B.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mitumfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

Die vorliegende Erfindung gründet sich auf die nachfolgend in Kurzform dargelegten physikalischer Erscheinungen und Effekte.

- In einem geschlossenen thermoelektrischen Stromkreis sind Seebeck- und Peltier-Effekt untrennbar miteinander verbunden. In der erwärmten Kontaktfläche eines Thermoelementes treten beide Effekte gleichzeitig und unmittelbar auf und sind jeweils nur Teil ein und desselben physikalischen Energie Umwandlungs Prozesses.

- In einem Thermoelement entsteht die Thermospannung auch dann in voller Höhe, wenn die zu erwärmende Verbindungsstelle (Kontaktstelle) zwischen den beiden Thermoschenkeln auch nur einen kleinen Bruchteil an leitender Querschnittsfläche aufweist, die ansonsten bei vollständiger Ausnutzung der durch die Leitungsquerschnitte der Thermoschenkel zur Verfügung stehenden Kontaktfläche gegeben wäre.

- Zur Aufrechterhaltung des spannungserzeugenden Temperaturgradienten genügt es, die erforderliche Wärmeenergie nur in der drastisch verkleinerten Kontaktfläche zuzuführen.

- Die dafür per Zeiteinheit einzubringende Wärme-Menge beträgt dabei ebenfalls nur einen, wenn auch nicht direkt proportionalen Bruchteil der ansonsten aufzuwendenden Wärme-Menge, als wenn eine, dem gesamten Leitungsquerschnitt entsprechende, oder noch großflächiger ausgeführte Kontaktfläche vorhanden wäre.

- Die Einleitung von Wärme in die drastisch verkleinerte, leitende Verbindungsstelle zwischen den beiden Thermoschenkeln, kann mit entsprechender thermischer Isolierung der Umgebung gezielt auf diese vorgenommen werden.

Dafür stehen folgende, grundsätzliche Möglichkeiten offen:

Die "punktuell" oder "linear" ausgerichtete, eng auf die minimierte Kontaktzone begrenzte, direkte Erwärmung durch heiße Gase oder Flüssigkeiten, sowie durch gegebenenfalls auch konzentrierte, thermisch wirksame Strahlung.

Die "punktuell" oder "linear" ausgerichtete, eng auf die kleine Kontaktzone begrenzte, thermisch leitende Berührung mit einem entsprechend ausgeformten, wärmeleitenden Festkörper.

Die direkte Einbringung von Wärme in die kleine Kontaktzone vermittels einer (bevorzugt dünnen) thermisch und elektrisch gut leitenden Schichte, welche die Materialien der beiden Thermoschenkel auf der den Abmessungen der drastisch reduzierten Kontaletzone entsprechenden Querschnittsfläche verbindet und die bevorzugt, aber nicht unabdingbar, nach außen hin verlängert, verbreitert, verdickt ist und die solcherart eine von außen aufgenommene Wärme an die kleinen Kontaktfläche(n) heranführen kann.

- Die Umsetzung von Wärme-Energie in elektrische Energie findet ausschließlich in den Molekularschichten der die Thermoschenkel verbindenden, erwärmten Kontakt-Grenzfläche (und nur dort) statt.

- Begründet ist dies durch die, in Festkörpern geltende, extrem kurze "mittlere freie Weglänge" thermisch angeregter Elektronen, die im Nanometer-Bereich liegt.

- Die sich im geschlossenen, thermoelektrischen Leiterkreis, zufolge der erzeugten Thermospannung einstellende Stromstärke, folgt dabei ausschließlich dem Ohmschen Gesetz und wird somit nur durch den Gesamtwiderstand des geschlossenen Leiterkreises begrenzt.

- Die im geschlossenen, thermoelektrischen Leiterkreis, zufolge der erzeugten Thermospannung vorliegende Stromstärke und Stromrichtung, entzieht der erwärmten Kontakt-Grenzschichte (und nur dort) über den Wirkungsmechanismus des Peltier-Effektes genau jene Wärmemenge, die dem Energieäquivalent der erzeugten Elektrischen Leistung entspricht.

- Je kleiner die erwärmte Kontaktzone in Relation zum gemittelten Leitungsquerschnitt der Thermoschenkel ist, desto höher ist der proportionale Anteil an Wärmeenergie der der Kontaktfläche über den Peltier-Wirkungsmechanismus per Zeiteinheit entnommen und damit entzogen wird um das Energieäquivalent für die sich im thermoelektrischen Leiterkreis einstellende elektrische Leistung zu erhalten.

- Bewirkt wird dies dadurch, dass die in ihrem Leitungs-Querschnitt drastisch reduzierte Kontaktfläche für den im geschlossenen Leiterkreis fließenden Strom eine erhebliche Querschnittsverjüngung darstellt. Dadurch liegt innerhalb dieser Querschnittsverjüngung eine entsprechend hohe Stromdichte vor. Der Peltier-Wirkungsmechanismus und somit die der Kontakt-Grenztfläche per Zeiteinheit entzogene Wärmemenge verhält sich zu der, in der Kontaktfläche vorliegenden Stromdichte proportional.

- Die Wärmeentnahme aus der Kontakt-Grenzfläche erfolgt unmittelbar und bewirkt eine ebenso unmittelbare Abkühlung der Kontaktfläche. Dieser Wärmeverlust muss zur Aufrechterhaltung der im geschlossenen Stromkreis vorliegenden elektrischen Leistung permanent ergänzt werden.

- Jede, über den unmittelbar angrenzenden Molekularbereich der erwärmten Kontaktfläche hinausgehende Erwärmung der beidseits vorhandenen Materialmassen, hat an der Energieumwandlung keinen direkten Anteil, sondern ist als ein den Wirkungsgrad einschränkender Wärme-Verlust zu betrachten.

- Die durch die minimierte, zu erwärmende Kontakt-Querschnittsfläche bedingte Erhöhung des Ohmschen Innenwiderstandes jedes Thermoelementes verursacht eine Reduzierung der elektrischen Leistung. Dieser Leistungsverlust ist bei erfindungsgemäßer Gestaltung der Thermoelemente jedoch wesentlich geringer als vermutet und bewegt sich nur in einer Größenordnung von 40 % - 50 %. Die Wärmeverluste der drastisch verkleinerten, erhitzten Kontaktfläche an die angrenzenden Thermoschenkel sind im Vergleich dazu weitaus geringer. Dadurch verschiebt sich die Proportionalität zwischen geringerer Leistung und der entstehenden (Wärme-)Verluste, was letztlich in einer Erhöhung des Wirkungsgrades resultiert.

Aus den bisherigen Darlegungen ist erkennbar, dass es zum Erhalt eines hohen thermoelektrischen Wirkungsgrades einer Methode bedarf, die detailliert darauf abzielt, der einen Thermoelektrischen Generator bildenden Vielzahl von einzelnen Thermoelementen im Idealfall nur jeweils jene Wärmemenge per Zeiteinheit zuzuteilen, die dem Energieäquivalent der vom jeweiligen Thermoelement erzeugten elektrischen Leistung entspricht. Dabei soll diese benötigte Wärmemenge sich auf dem höchstmöglich anwendbarem Temperaturniveau befinden. Theoretisch kann dadurch ein extrem hoher Wirkungsgrad erreicht werden. Der erfindungsgemäße Lösungsweg hiezu wird durch einen Verbindungskontakt von im Vergleich zum Leitungsquerschnitt der Thermoschenkel extrem verkleinerten Leitungsquerschnitt realisiert und das erforderliche Temperaturniveau soweit wie möglich nur in diesem minimierten Leitungsquerschnitt zur Verfügung gestellt.

In der Praxis müssen bisher jedoch noch Kompromisse eingegangen werden. Die vorliegende Erfindung stellt einen solchen Kompromiss dar und erzielt bereits einen beträchtlichen Fortschritt in Richtung hoher Effizienz. Erreicht wird dies dadurch, dass die zu erwärmende Verbindungsstelle zwischen den beiden Thermoschenkeln jedes Thermoelementes nur eine Kontakt-Verbindungsfläche aufweist, die maximal 5 %, bevorzugt jedoch weniger, des "Gemittelten Gesamt-Leitungsquerschnittes" der beiden Thermoschenkel jedes Thermoelementes beträgt.

Als "Gemittelter Gesamt-Leitungsquerschnitt" $\overline{\omega}$ eines Thermoelementes gilt dabei jener reale oder auch nur hypothetische Wert, der sich ergibt, wenn man das Material-Volumen jedes der beiden ein Thermoelement bildenden Thermoschenkel mit dessen jeweiliger, den durchgehenden Stromfluss leitenden Länge in Bezug bringt. Es gilt dabei die Beziehung:

$$\varpi = \frac{V_A}{1_A} + \frac{V_B}{1_B}$$

Es bezeichnen dabei:

$\overline{\omega} =$    Gemittelter Gesamt-Leitungsquerschnitt beider Thermoschenkel
$V_A =$    Volumen des Thermoschenkels A
$V_B =$    Volumen des Thermoschenkels B
$1_A =$    leitende Länge des Thermoschenkels A
$1_B =$    leitende Länge des Thermoschenkels B

Der Begriff des "Gemittelten Gesamt-Leitungsquerschnittes" wird deshalb für die vorliegende Erfindung verwendet, weil je nach zweckdienlicher Ausführungsform eines Thermoelementes, die betreffenden Thermoschenkel unterschiedliche Länge und Dicke, sowie einen veränderlichen Querschnitt aufweisen können.

Der "Gemittelte Gesamt-Leitungsquerschnitt" dient dazu, für die unterschiedlichen Ausführungsformen von Thermoelementen eine einheitliche Rechengrundlage für die Dimensionierung der der Erfindung zugrundeliegenden, minimierten Kontakt-Querschnittsfläche zu erhalten.

Die für die vorliegende Erfindung bisher dargelegten Grundlagen, Prinzipien und Wirkungsweisen enthalten das kennzeichnende Wesen der Erfindung, nämlich das Prinzip des in seiner Querschnittsfläche minimierten Kontakt-Überganges, das Prinzip der limitierten Zuführung von Wärme-Energie direkt in diesen verkleinerten Kontaktbereich, sowie das Prinzip, den eigentlichen Umwandlungsprozess von Wärme in elektrische Energie nur auf einer sehr klein gehaltenen Kontaktzone stattfinden zu lassen, sodass die für die Transformation gleichzeitig und unmittelbar benötigte Wärme-Energie auch nur dort über den Wirkungs-Mechanismus des Peltier-Effektes entnommen werden kann und auch nur dort wieder ergänzt wird.

Da aber auch der minimierte, permanent auf Temperatur zu haltende Kontakt-Übergang infolge der Wärmeleitfähigkeit der unmittelbar angrenzenden Material-massen der Thermoschenkel Wärmeverluste erleidet die ergänzt werden müssen und somit den Wirkungsgrad reduzieren, kann zur weiteren Verbesserung des Wirkungsgrades nicht nur die bisher übliche Methode, nämlich Thermoschenkel Materialien zu verwenden, die ein geringes Wärmeleitvermögen besitzen, angewendet werden.

Eine zusätzlich anwendbare Methode besteht darin, die Leitungsquerschnitte der ein Thermoelement bildenden beiden Thermoschenkel-Materialien in einem solchen proportionalen Verhältnis zueinander zu verändern, dass entweder geringster Ohmscher Widerstand und damit höchstmögliche elektrische Leistung vorliegt, oder die Verhältnisse auf höchsten, Thermischen Widerstand abzustimmen, womit geringst mögliche Verluste infolge Wärmeströmung vorliegen.

Im Falle der Anpassung an geringsten Ohmschen Widerstand wird so vorgegangen, dass der Leitungsquerschnitt des die Elektrizität schlechter leitenden Materiales vergrößert wird und jener des besser leitenden Materiales verringert wird.

Sinnvoll ist die Anwendung dieser zusätzlichen Methode hauptsächlich dann, wenn zwischen den beiden, die Thermoschenkel bildenden Materialien ein deutlicher Unterschied in der elektrischen Leitfähigkeit vorliegt. Unter der Annahme, dass beide Thermoschenkel A, B gleiche Länge und zunächst gleichen Querschnitt aufweisen, kann der Proportionalitätsfaktor des gesuchten Minimal-Widerstandes leicht ermittelt werden nach der Beziehung

$$R_{opti} = \frac{(\sqrt{\sigma_A}+\sqrt{\sigma_B})^2}{2(\sigma_A + \sigma_B)}$$

Es bezeichnen dabei:

Ropti = optimierter (= geringster) Serien-Widerstand der beiden Thermoschenkel (A, B)

$\sigma_A$ = elektrische Leitfähigkeit des Materiales A

$\sigma_B$ = elektrische Leitfähigkeit des Materiales B

Wendet man diese Formel beispielsweise auf die, in dieser Schrift nur als Rechenbeispiel zu betrachtende, bekannte Materialkombination Kupfer-Konstantan an, wo der Unterschied in deren elektrischer Leitfähigkeit auffällig hoch ist, so erhält man:

$$\text{Kupfer (A)} \ldots\ldots \sigma_A = 58 \cdot 10^6 \text{ S/m}$$

$$\text{Konstantan (B)} \ldots\ldots \sigma_B = 2 \cdot 10^6 \text{ S/m}$$

$$\sigma_A + \sigma_B = 60 \cdot 10^6 \text{ S/m}$$

$$_{opti}R_{CuKo} = \frac{\left(\sqrt{\sigma_A}+\sqrt{\sigma_B}\right)^2}{2\left(\sigma_A+\sigma_B\right)} = \frac{\left(\sqrt{58}+\sqrt{2}\right)^2}{2.60} = \frac{9,0296^2}{120} = 0,6794 \rightarrow \text{Proportionalitätszahl}$$

Der erhaltene Wert von 0,6794 bedeutet, dass im Unterschied zu dem (Ohmschen-) Widerstand, den die beiden Thermoschenkel von gleichem Leitungsquerschnitt in Reihenschaltung miteinander verursachen, dieser Widerstand auf den Faktor 0,6794, d.h. nahezu um ein Drittel reduziert werden kann, wenn anstelle gleicher Leitungsquerschnitte, der Querschnitt des schlechter leitenden Materiales (im angeführten Beispiel = Konstantan) vergrößert wird, während der Leitungsquerschnitt des besser leitenden Materiales (im angeführten Beispiel = Kupfer) verringert wird. Die Summe beider Leitungsquerschnitte in der wertfreien Größenordnung 2 wird dabei nicht verändert, sodass sich auch die Gesamtabmessungen des solcherart modifizierten Thermoelementes nicht verändern.

Die Berechnung der Proportionalitätszahl für den optimalen (geringsten) Widerstand gibt zunächst nur eine rasch verfügbare Entscheidungshilfe, ob eine Querschnitts-Optimierung sinnvoll ist oder nicht. Die Proportionalitätszahl gibt aber noch keine Aussage darüber, in welcher Relation sich die beiden Thermoschenkel-Querschnitte verhalten müssen, um bei gleichbleibenden Gesamtabmessungen des Thermoelementes den optimalen (geringsten) Widerstand zu erhalten. Die Berechnung dieser Verhältnisse erfolgt gemäß nachstehender Beziehung:

$$f(x) = z = \frac{\frac{1}{\sigma_A}}{x} + \frac{\frac{1}{\sigma_B}}{2-x}$$

Die Auflösung obiger Funktion resultiert letztlich in einer quadratischen Gleichung. Für $\sigma_A$ ist stets der höhere der beiden elektrischen Leitwerte zu verwenden. Im vorliegenden, nur der Demonstration dienenden Beispiel wäre dies der Leitwert des Kupfers.

$$\rho_A = \frac{1}{\sigma_A} \qquad\qquad x_{1,2} = -\frac{2\rho_A}{(\rho_B - \rho_A)} \pm \sqrt{\left[\frac{2\rho_A}{(\rho_B - \rho_A)}\right]^2 + \frac{4\rho_A}{(\rho_B - \rho_A)}}$$

$$\rho_B = \frac{1}{\sigma_B}$$

Von den beiden x-Werten ist nur der positive Wert relevant. Für das vorliegende, nur der demonstrativen Erläuterung dienende Beispiel eines Kupfer-Konstantan Thermoelementes und unter der Voraussetzung, dass gleiche Schenkellängen zur Anwendung gelangen, erhält man mit obiger Formel die Werte:

$$x = \varnothing A = 0{,}313 \qquad \rightarrow \text{Proportionszahl für } \varnothing A \text{ (Cu)}$$
$$2\text{-}x = \varnothing B = \underline{1{,}687} \qquad \rightarrow \text{Proportionszahl für } \varnothing B \text{ (Kon)}$$
$$\varnothing A + \varnothing B = 2{,}000$$

Der geringste Widerstand der beiden aus Kupfer und Konstantan bestehenden Thermoschenkel ist im gegenständlichen Beispiel also dann gegeben, wenn sich Querschnitt Kupfer : Querschnitt Konstantan verhält wie 0,313 : 1,687, oder anders formuliert, 1 : 5,39.

Mit der Reduzierung des Widerstandes findet beim gegenständlichen Demonstrations-Rechenbeispiel eine Leistungserhöhung auf den Faktor 1,472 statt.

Mit der Veränderung der Schenkel-Querschnitte findet aber gleichzeitig auch eine Veränderung des das Thermoelement durchfließenden Wärmestromes statt. Die dahingehende Berechnung zeigt, dass sich der durchfließende Wärmestrom auf den Faktor 0,3767, oder in anderen Worten auf 37,67 % relativ, bezogen auf den Wärmestrom der das nicht querschnittsoptimierte Thermoelement durchfließt und hier als 100 % relativ betrachtet wird, reduziert.

Aus der Leistungserhöhung bei gleichzeitig vermindertem Wärmestrom ergibt sich im vorliegenden Beispiel, dass dadurch der Wirkungsgrad des querschnitts-optimierten Kupfer-Konstantan Thermoelementes das 3,9-fache beträgt als jener, der für gleichdimensionierte Schenkel gilt. Die in dieser Schrift angeführten Berechnungsgrundlagen gelten für alle Thermoelement-Material-Kombinationen, so fern gleiche Schenkellängen zur Anwendung gelangen. Ist dies nicht der Fall, so müssen die Material-Kennwerte jenes Materiales, aus dem der längere der beiden Schenkel gebildet wird, mit entsprechenden Korrektur-Parametern beaufschlagt werden.

Eine weitere Möglichkeit, die verlustreiche Wärmeströmung vom erwärmten zum kalten Ende der Thermoschenkel bestmöglich zu begrenzen besteht darin, die Leitungsquerschnitte der Thermoschenkel umgekehrt proportional zu deren Wärmeleitvermögen zu dimensionieren. Unter der Voraussetzung gleicher Schenkellängen erhält man die Dimensionierungsverhältnisse (Proportionen) durch die Beziehung

$$\varnothing A : \varnothing B = \lambda A : \lambda B$$

Auch alleine damit kann, je nach den $\lambda$-Materialkennwerten (Wärmeleitfähigkeit) eine gelegentlich signifikante Erhöhung des Wirkungsgrades stattfinden.

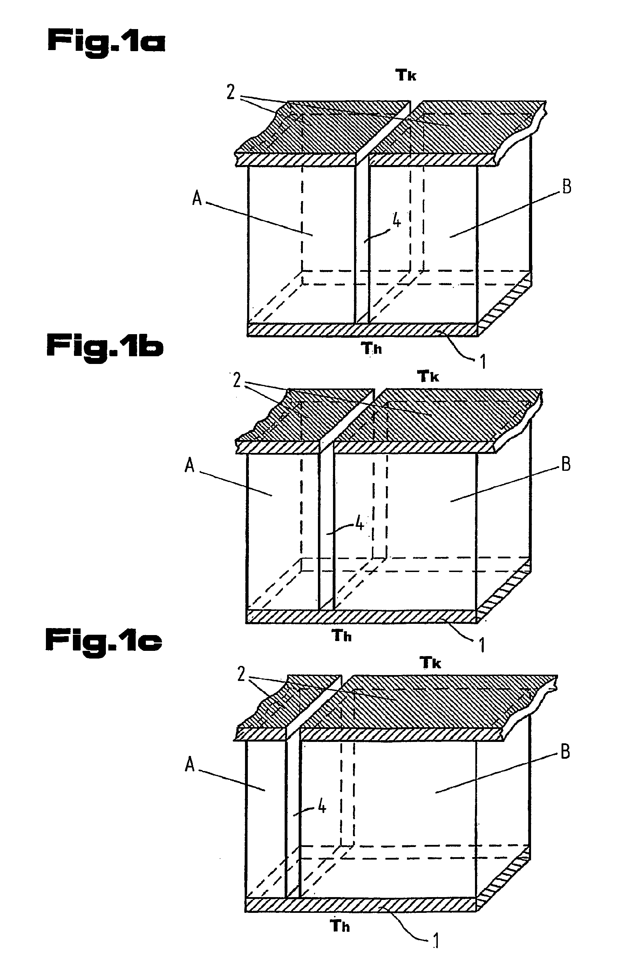

In Fig. 1a ist ein Thermoelement konventioneller Bauform dargestellt. Die aus HalbleiterMaterial bestehenden Thermoschenkel A und B sind gleich groß und an den zu erwärmenden Enden durch eine Kontaktbrücke 1 aus gut thermisch und elektrisch leitendem Material vollflächig über ihre jeweils gesamte, leitende Querschnittsfläche 3, die gleichzeitig auch der Bodenfläche) entspricht, verbunden.

Diese Seite des Thermoelementes ist der höheren Temperatur Th ausgesetzt. Das dem kühlenden Temperaturbereich $T_k$ zugewandte Ende des Thermoelementes weist die Kontaktbrücken 2 auf, die jeden der beiden Thermoschenkel A, B mit einem benachbarten, in der Abbildung nicht mehr dargestellten Thermoelement seriell verbindet. Die Thermoschenkel sind durch den Spalt 4 gegeneinander getrennt. In Fig. 1b ist ein gleichartiges Thermoelement vorgestellt, wobei jedoch dessen Thermoschenkel A, B der Querschnittsoptimierung für geringsten Widerstand unterzogen sind. Die dargestellten Größenverhältnisse zeigen das optimale Verhältnis wie es sich ergäbe, wenn das Material A eine 4-fach bessere thermische und elektrische Leitfähigkeit aufweist als das Material B. Der mit den dargestellten Proportionen erzielte Wirkungsgrad hat einen Erhöhungs-Faktor von 1,36 und ist damit um 36 % besser als jener, der mit den Standard-Proportionen nach Fig. 1a erzielt würde. Fig. 1c zeigt ein gleichartiges Thermoelement, dessen Thermoschenkel A, B der Querschnittsoptimierung für geringsten thermischen Durchfluss folgen. D.h., die Querschnittsverhältnisse sind der Wärmeleitfähigkeit $\lambda$ der Materialien umgekehrt proportional. Der mit den in Fig. 1c dargestellten Schenkel-Proportionen erzielte Wirkungsgrad hat einen Erhöhungs-Faktor von 1,46 und ist damit um 46 % besser als jener, der mit den Standard-Proportionen nach Fig. 1a erzielt würde.

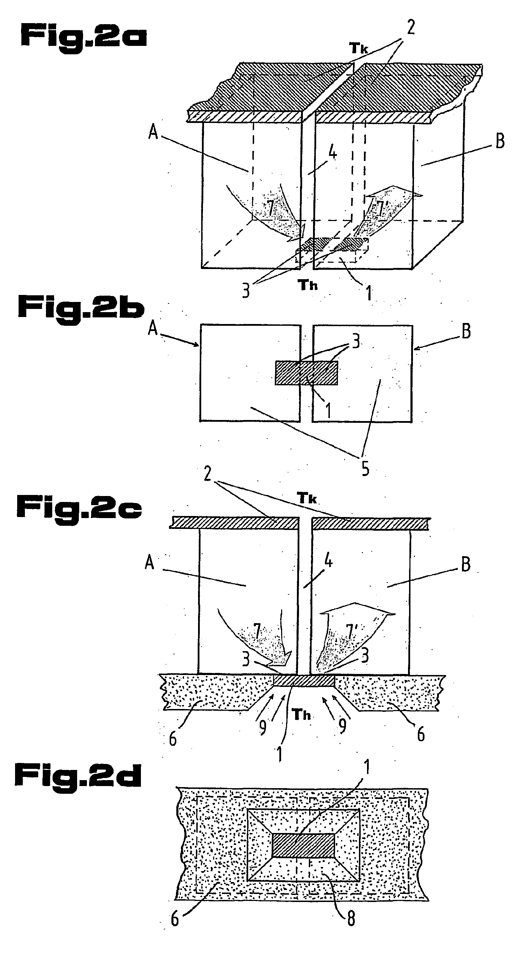

Fig. 2a zeigt ein Thermoelement, das erfindungsgemäß mit minimierten Kontakt-Querschnittsflächen 3 ausgestattet ist. Der "Gemittelte Gesamt-Leitungsquerschnitt" ist im Fall der Fig. 2a leicht errechenbar, weil die Thermoschenkel A, B gleiche Länge und gleiche (Quader-) Form aufweisen, sodass jeder der beiden Leitungsquerschnitte identisch ist mit den Bodenflächen 5. Die leitende Verbindung in der Temperaturzone Th ist durch die nun erheblich verkleinerte Verbindungsbrücke 1 gegeben. Die Abbildung repräsentiert ein Kontakt-Querschnittsverhältnis von 3 %. Gemeint ist damit, dass die Kontaktflächen 3 die die beiden Thermoschenkel A, B leitend miteinander verbinden, jeweils eine Fläche von 3 % des "Gemittelten Gesamt-Leitungsquerschnittes,,, der sich im vorliegenden Fall aus der Summe der beiden Bodenflächen 5 ergibt, einnehmen. Der den Thermoschenkel A durchfließende, elektrische Strom 7, 7' erleidet dabei eine beträchtliche Einschnürung um durch die minimierte Kontaktfläche bei A einzutreten und bei der in B befindlichen Kontaktfläche 3 wieder auszutreten und durch den Thermoschenkel B mit sich wieder erweiterndem Querschnitt weiter zu fließen. Fig. 2b zeigt die Ansicht von unten. Die Kontaktbrücke 1 ist nur über die Kontaktflächen 3 mit den beiden Thermoschenkeln A, B verbunden. In Fig. 2c ist dargestellt, dass die Wärmezuführung 9 nur auf die Kontaktbrücke 1 ausgerichtet ist. Die der temperaturzone Th zugewandten (Boden-) Flächen von A und B sind mit Ausnahme der Kontaktbrücke 1 durch eine gut wärmedämmende Materialschichte 6 gegen den Einfluss von Th abgeschirmt. Nur die Kontaktbrücke 1, die sich in einer Senke 8 der Wärmeabschirmung 6 befindet, ist der aus dem Bereich Th zugeführten Wärme direkt ausgesetzt. Die Wärmequelle kann durch irgendeine der zuvor beschriebenen Arten repräsentiert sein.

Durch die Kontaktbrücke 1 wird den minimierten Kontaktflächen 3, genauer ausgedrückt den dort vorhandenen Kontakt-Grenzschichten die entsprechende Wärmemenge übermittelt. Nur in den kleinen Kontakt-Grenzschichten ist der kombinierte Seebeck / Peltier-Effekt wirksam. In Fig. 2d ist die der Wärmezuführung ausgesetzte Unterseite der Kontaktbrücke 1, welche sich eingebettet in der Senke 8 der thermischen Isolierschichte 6 befindet, dargestellt.

Die im angeführten Beispiel eine Fläche von nur 3 % des "gemittelten Gesamt-Leitungsquerschnittes" aufweisenden Kontakt-Grenzschichten werden dadurch von einer vergleichsweise hohen Stromdichte durchflutet. Über den Peltier-Wirkungsmechanismus wird nur diesen kleinflächigen Zonen das gesamte, der elektrischen Leistung des Thermoelementes entsprechende Energie-Äquivalent an Wärme unmittelbar entzogen. Die Kontaktbrücke 1 muss durch entsprechenden Wärmeleitwert, Materialstärke, sowie Temperaturgradient die per Zeiteinheit erforderliche Wärmemenge den Kontakt-Grenzschichten permanent nachliefern. Zuzüglich zu dem Energie-Äquivalent für die elektrische Leistung, muss auch der Wärmeverlust den die Kontakt-Grenzschichten durch den thermischen Kontakt mit dem Material der angrenzenden Thermoschenkel A, B erleiden, ergänzt werden.

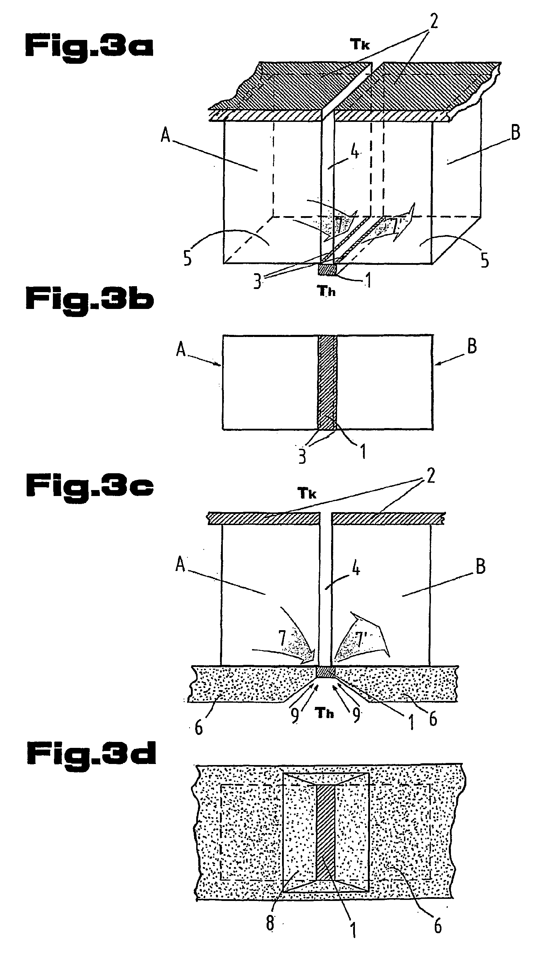

In Fig. 3a ist analog zu den vorangegangenen Beispielen ein Thermoelement dargestellt, in dem das erfindungsgemäße Grundprinzip dahingehend umsetzt ist, dass die minimierte Kotakt-Querschnittsfläche "lineare" Ausrichtung besitzt. Gemeint ist damit, dass die Kontakt-Querschnittsflächen durch zwei sehr schmale und in ihrer Länge der Materialdicke der Thermoschenkel folgende Streifen dargestellt werden. Die Berechnungen zeigen, dass dadurch der Innenwiderstand des Thermoelementes kleiner gehalten werden kann, als bei der "punktuellen", d.h. auf einen kleinen Fleck bezogenen Ausrichtung, wie sie in Fig. 2 vorgestellt wurde.

In Fig. 3a betragen die Kontakt-Querschnittsflächen 3 nur 2 % des "Gemittelten Gesamt-Leitungsquerschnittes". Die beiden Thermoschenkel A, B sind an ihren, der Temperaturzone Th ausgesetzten Enden nur entlang der beiden gegenüberliegenden Kanten durch je einen schmalen, den Kontakt-Querschnitt ausbildenden Streifen miteinander verbunden. Dies entspricht der weiter oben erwähnten "linearen" Modifikation. Die Kontaktbrücke 1 reicht nur wenig über die jeweilige Kante hinaus. Die Einschnürung des das Thermoelement durchfließenden Stromes 7, 7' erfolgt dadurch nur über zwei Raumachsen anstelle von 3 Achsen wie bei der "punktuellen" Ausrichtung. Damit geht ein geringerer Elementen-Widerstand einher. Für Fig. 3b, 3c, 3d gelten hinsichtlich Aufbau, Funktionsweise und Anwendung sinngemäß die gleichen Erläuterungen, wie bereits für Fig. 2b, 2c, 2d expliziert.

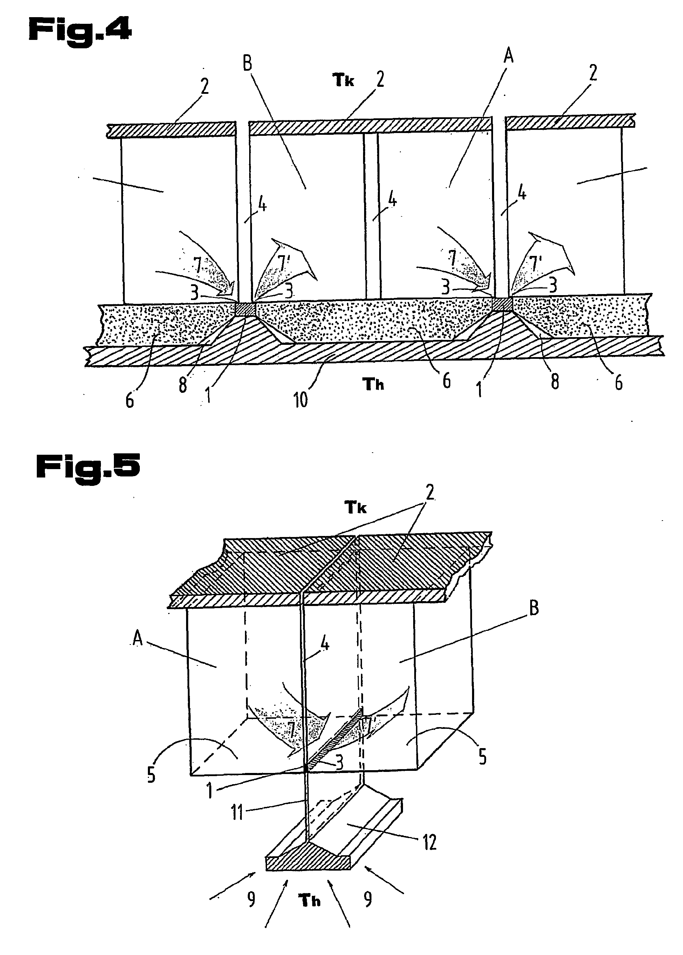

In Fig. 4 ist eine Serienschaltung von zwei Thermoelementen dargestellt, die in Ihrem Aufbau jenem der Fig. 3a entsprechen. Der leitende Kontakt-Querschnitt 3 entspricht dabei wieder 2 %. Das Beispiel der Fig. 4 zeigt auf, dass die Wärmezuführung an die Kontaktbrücken 1 auch auf indirekte Art durchgeführt werden kann. Ein Festkörper 10 aus bevorzugt gut thermisch leitendem Material weist an seiner Oberfläche eine Profil-Struktur auf, die in die Senken 8 der Wärmeisolierung 6 hineinreichen und in thermisch leitender Berührung mit den Kontaktbrücken 1 stehen. Der Festkörper 10 kann beispielsweise die Wand eines von heißen Gasen oder heißen Flüssigkeiten durchströmten Rohres oder Schachtes sein. Die von ihm aufgenommene Wärme wird an die Kontaktbrücken 1 weiter gegeben.

Fig. 5 zeigt eine bevorzugte Anwendungsform des erfindungsgemäßen Funktionsprinzips. Die beiden Thermoschenkel A, B sind einander soweit genähert, dass nur ein sehr schmaler, isolierenden Trennspalt 4 ausgebildet wird.

Der Trennspalt 4 kann auch durch eine Trennschichte aus elektrisch isolierendem Material ersetzt werden. In solchem Fall reicht die isolierende Trennschichte nicht gänzlich bis zu den Bodenflächen 5 der Thermoschenkel A, B.

In die Spalte 4 reicht über die Länge der beiden dortigen Kanten eine in dieser Schrift als "Thermozunge" 11 bezeichnete, dünne Platte aus thermisch und elektrisch gut leitendem Material, bevorzugt Kupfer, ein kleines Stück hinein. Dieser Teil der "Thermozunge" 11 ist mit den Thermoschenkeln A, B gut leitend verbunden und ersetzt somit die bisher beschriebenen Kontaktbrücken 1. Gleichzeitig wird dadurch auch die minimierte Kontakt-Querschnittsfläche 3 erhalten. Im vorgestellten Beispiel der Fig. 5 beträgt diese Kontakt-Querschnittsfläche 4 % des "Gemittelten Gesamt-Leitungsquerschnittes". Die "Thermozunge" 11 ist an ihrem, dem Temperaturniveau Th zugewandten Ende gegebenenfalls erheblich verbreitert, verdickt oder zusätzlich auch profiliert. Der in dieser Schrift nachfolgend als "Thermofuß" 12 bezeichnete Teil der Thermozunge 11 hat die Aufgabe, aus einer wie auch immer gearteten Wärmequelle thermische Energie in hinreichender Menge aufzunehmen und über die "Thermozunge" 11 an die minimierten Kontakt-Querschnittsflächen 3 weiter zu leiten. Die Dimensionierung der Thermozunge 11 und des Thermofußes 12 außerhalb der von der Thermozunge 11 selbst gebildeten Kontaktbrücke 1 richtet sich nach den Material-Kennwerten, dem Temperaturniveau sowie dem Wärmebedarf der Kontakt- Querschnittsflächen 3.

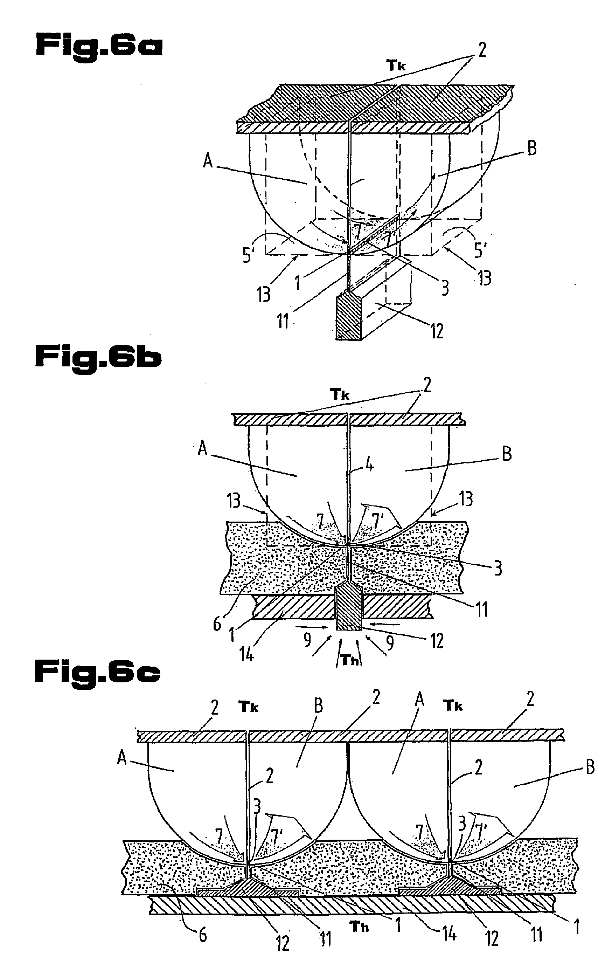

In Fig. 6a ist eine verbesserte, bevorzugte Anwendungsform des erfindungsgemäßen Grundprinzips dargelegt. Die Thermoschenkel A, B haben eine in Richtung der minimierten Kontakt-Querschnittsfläche weisende, abgerundete Form und somit einen, sich über die leitende Länge der Thermoschenkel verändernden Leitungsquerschnitt. Das heißt, ein Querschnitt der Thermoschenkel A, B weist bezüglich einer die Kontaktbrücken 1, 2 schneidenden Ebene eine zumindest annähernd kreisbogenförmige und konvexe Begrenzung auf. Die gerundete Form folgt weitestgehend dem effektiven und sich einschnürenden Stromverlauf 7, 7' zu den "linear" konfigurierten Kontakt-Querschnittsflächen 3. Im Gegensatz zu der in Fig. 5 dargestellten Version ist damit auch eine Einsparung an Thermoelement-Material verbunden. In der Version der Fig. 5 ist nämlich zufolge der Strom-Einschnürung nicht mehr die gesamte Materialmasse jedes Thermoschenkels an der Fortleitung des Stromes beteiligt. Die abgerundete Form der Thermoschenkel A, B wie in Fig. 6a, 6b, 6c dargestellt, berücksichtigt dies. Die in Richtung der Kontakt-Querschnittsflächen 3 auftretende, der Stromeinschnürung kontinuierlich folgende Reduzierung der Schenkelquerschnitte, reduziert auch die Wärmeableitung aus den Kontakt-Querschnittsflächen 3. Die unterbrochenen Linien 13 zeigen und begrenzen für jeden der beiden Thermoschenkel einen hypothetischen, quaderförmigen Körper, der das Volumens-Äquivalent für den zugehörigen Thermoschenkel, bei gleicher Leiterlänge darstellt. In der Fig. 6 sind die abgerundeten Thermoschenkel A, B von gleicher Größe und Länge, weshalb auch die beiden hypothetischen, quaderförmigen Volumens-Äquivalente gleich groß sind. Die Grundflächen 5' der hypothetischen Körper entsprechen dem "gemittelten Leitungs-Querschnitt" jedes der beiden Schenkel A, B und werden aus der in dieser Schrift bereits weiter oben definierten Beziehung für $\overline{\omega}$ erhalten. Die Addition der beiden Flächen 5' ergibt den "Gemittelten Gesamt-Leitungsquerschnitt" des Thermoelementes, woraus Größe und %-Wert für die Kontakt-Querschnittsfläche 3 bestimmt werden kann. In den Beispielen der Fig. 6a, 6b, 6c beträgt die minimierte Kontakt-Querschnittsfläche 2 % vom "Gemittelten Gesamt-Leitungsquerschnitt". Die Thermozunge 11 ist im Bereich von Th zu einem "Thermofüß" 12 vergrößert.

Fig. 6b zeigt die praktische Anwendungsform dieser Variante. Die Thermozunge 11 und ein Teil des Thermofußes 12 ist von einer wärmeisolierenden Schicht 6 umgeben. Der Thermofuß 12 reicht durch die Öffnung einer Wand 14 hindurch. Die Wand 14 kann die Wand eines Rohres oder eines Schachtes sein, in dem ein gasförmiger oder flüssiger Wärmeträger zirkuliert. Die vom Thermofuß 12 aufgenommene Wärmeenergie 9 wird über die Thermozunge 11 an die Kontaktstellen bzw. Die Kontakt-Querschnittsfläche 3 weitergegeben.

Fig. 6c zeigt einen Ausschnitt aus einer Serienschaltung solcher erfindungskonform ausgeführter Thermoelemente. Die Thermozunge 11 ist kürzer ausgeführt und mit einem breiten, flachen Thermofuß 12 versehen. Dieser steht in flächigem, thermisch gut leitendem Kontakt mit einer Wand 14, die sich auf dem Temperaturniveau Th befindet, was durch irgend eine der zuvor beschriebenen Arten bewerkstelligt wird (beispielsweise durch heiße Gase, heiße Flüssigkeiten oder Adsorption thermisch wirksamer Strahlung). Die vom Thermofuß 12 aufgenommene Wärmeenergie wird über die Thermozunge 11 an die Kontakt-Querschnittsfläche 3 weitergegeben.

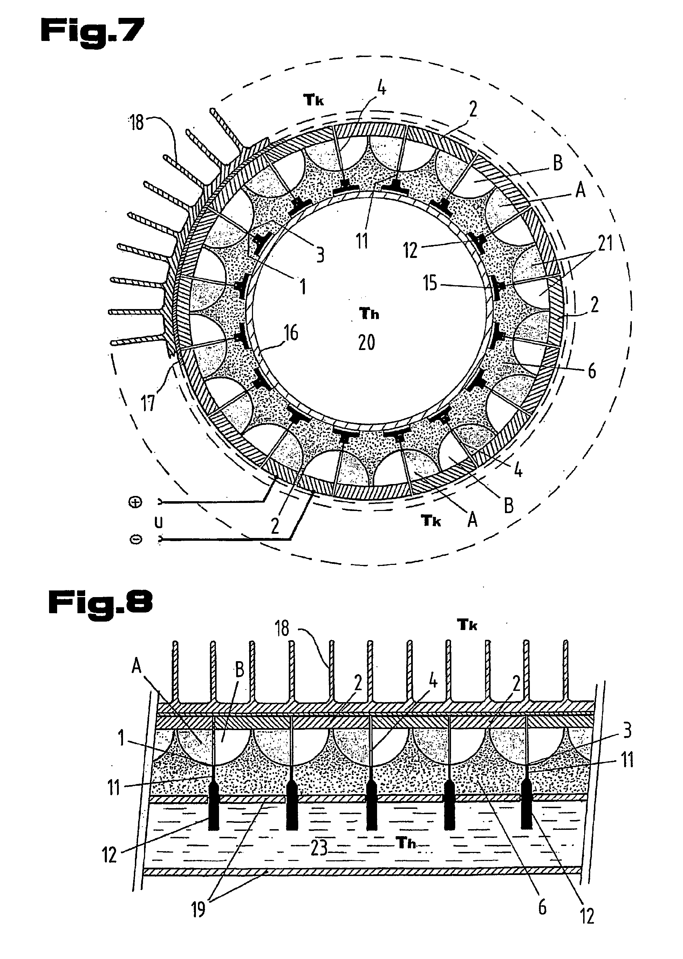

Fig. 7 zeigt einen nach den Grundkonzepten der vorliegenden Erfindung ausgeführten Thermogenerator in Radial-Bauweise.

Um die Wand eines zentralen Rohres 16 sind eine Anzahl von Thermoelementen 21 ringförmig angeordnet. Die Thermoelemente entsprechen der in Fig. 6 dargestellten Bauform mit abgerundeten Thermoschenkeln A, B. Die Kontaktbrücken 2 im Temperaturbereich $T_k$ verbinden jedes Thermoelement mit den benachbarten Thermoelementen in Serienschaltung. Die Kontaktbrücken 2 formen dabei einen konzentrischen, durch die Trennspalten 4 in regelmäßigen Abständen unterbrochenen Ring um das zentrale Rohr 16. An einer beliebigen Position 22 ist eine der Kontaktbrücken 2 geteilt, sodass dort die Spannung U der Serienschaltung abgegriffen werden kann. Die gerundeten Thermoschenkel A, B jedes Thermoelementes sind an den, dem zentralen Rohr 16 zugekehrten Kanten über eine Thermozunge 11, welche dort auch die minimierte Kontakt-Querschnittsfläche ausbildet, elektrisch verbunden. Die Thermozungen 11 sind jeweils mit einem Thermofuß 12 versehen, welcher in thermisch leitendem Kontakt mit der äußeren Oberfläche des zentralen Rohres 16 steht. Wenn das zentrale Rohr 16 aus elektrisch leitendem Material (beispielsweise Metall) besteht, ist jeder Thermofuß 12 durch eine dünne, elektrisch isolierende Zwischenschicht 15 vor direktem Kontakt mit dem Rohr 16 geschützt. Die Hohlräume zwischen dem Rohr 16, den Thermofüßen 12, den Thermozungen 11 und den Thermoelementen 21, sind durch ein gut wärmedämmendes und elektrisch isolierendes Material 6 ausgefüllt. Der unterbrochene Ring aus den Kontaktbrücken 2 ist von einer dünnen, elektrisch isolierenden Hülle 17 umgeben. Die Hülle 17 ist bevorzugt, aber nicht unabdingbar, von einem ringförmigen, mit Kühlrippen ausgestatteten Kühlkörper 18 umgeben. Solcherweise ist die kranzförmige Serienschaltung von Thermoelementen samt aller zugehörigen Teile zwischen dem zentralen Rohr 16 und dem konzentrischen, ringförmigen Kühlkörper 18 in festem, mechanischem Verbund eingeschlossen. In dem zentralen Rohr 16 liegt das Temperaturniveau Th vor, das entweder durch heiße Gase, heiße Flüssigkeiten oder irgendeiner anderen, Wärme erzeugenden oder Wärme tragenden Substanz 20 bereitgestellt wird. Über die solcherart erhitzte Wand des Rohres 16 wird Wärme an die Thermofüße 12 übertragen und über die Thermozungen 11 an die minimierten Kontakt-Querschnittsflächen 3 weitergegeben. Dadurch wird der die Spannung U erzeugende Seebeck-Effekt hervorgerufen.

Soferne der elektrische Stromkreis geschlossen ist, tritt gleichzeitig und unmittelbar auch der begleitende Peltier-Effekt ein, welcher den Grenzschichten der minimierten Kontakt-Querschnittsflächen über die dort vorherrschende hohe Stromdichte das der elektrischen Leistung des Stromkreises entsprechende Energie-Äquivalent an Wärme unmittelbar entzieht.

Ein Thermogenerator kann aus einer Mehrzahl von Thermoelement-Kränzen, wie prinzipiell in Fig. 7 vorgestellt, entweder in Serienschaltung, Paralellschaltung oder einer beliebigen Kombination von beiden aufgebaut sein.

Fig. 8 zeigt den Ausschnitt eines auf den gleichen Grundprinzipien aufbauenden Anwendungsbeispieles. Das Anwendungsbeispiel berücksichtigt eine flache Bauform. Die Thermofüße 12 sind dabei von länglicher Struktur und ragen elektrisch isoliert durch die Wand eines flachen Rohres oder Schachtes 19 in dessen Hohlraum. In dem Hohlraum des Rohres oder Schachtes 19 wird durch irgendeine der zuvor beschriebenen Arten 23 das Temperaturniveau Th bereitgestellt. Die Thermofüße 12 nehmen aus dem Temperaturniveau Th Wärme auf, welche durch die Thermozungen 11 an die minimierten Kontakt-Querschnittsflächen 3 übermittelt wird. Das Rohr oder der Schacht 19 kann auch einen quadratischen oder rechteckigen Querschnitt aufweisen und die Thermoelemente mit den Thermozungen 11 und den Themofüßen 12 an allen ebenen Außenflächen des Rohres oder Schachtes 19 angebracht sein. Alle länglichen Themofüße 12 ragen dabei isoliert durch Bohrungen in den Hohlraum der Rohres oder Schachtes 19, in welchem das Temperaturniveau Th bereitgestellt wird.

Gemäß diesen Beispielen ist mit der gegenständlichen Erfindung ein Verfahrensweg zur direkten Umwandlung von Wärmeenergie in Elektrizität vorliegt, der einen sehr merklichen Fortschritt auf dem einschlägigen Fachgebiet möglich. Dieser gründet sich darauf, dass einerseits die dem Seebeck-Koeffizienten und dem Temperaturgradienten folgende Thermospannung in voller Wertigkeit auch dann entsteht, wenn die "heiße" Verbindungsstelle der Thermoelement-Materialien nur durch eine sehr kleine Kontaktstelle ausgeführt ist und die erforderliche Temperatur nur in dieser kleinen Kontaktstelle vorliegt. Andererseits tritt im geschlossenen Stromkreis gleichzeitig und unmittelbar zum Seebeck-Effekt auch unweigerlich der Peltier-Effekt auf, der der "heißen" Kontaktstelle und nur dieser, das Wärmeenergie-Äquivalent für die elektrische Leistung entzieht. Wird die erforderliche Zufuhr von Wärme-energie nur auf die sehr kleine Kontaktstelle beschränkt, so wird durch limitierte Zufuhr auch vordringlich nur diese Wärmeenergie umgewandelt. Die dennoch vorhandenen Wärmeverluste an das im Vergleich zur Kontaktstelle massive Material der angrenzenden Thermoschenkel sind um ein Vielfaches geringer als bei vollflächigem Kontakt. Der Leistungsverlust durch erhöhten Widerstand der Thermoelemente wird durch die wesentlich verkleinerten Verluste an Wärmeströmung mehrfach kompensiert. Daraus resultiert die grundsätzliche Verbesserung des Wirkungsgrades.

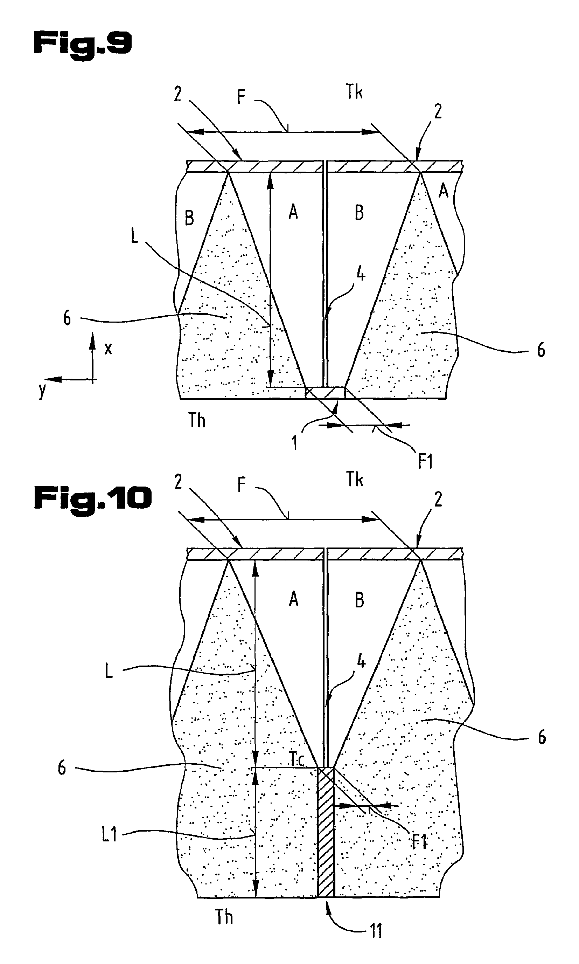

Die Fig. 9 zeigt ein alternatives Ausführungsbeispiel einer Thermoelementenanordnung mit einer annähernd keilförmigen Ausbildung der beiden Thermoschenkel A, B.

Die beiden Thermoschenkel A, B weisen jeweils einen trapezförmigen Querschnitt auf und sind so nebeneinander angeordnet, dass sich zwischen diesen ein schmaler Spalt 4 befindet. Von der ersten elektrischen Kontaktbrücke 1 hin zu den gegenüberliegenden Kontaktbrücken 2 nimmt die Breite der beiden Thermoschenkel A, B linear zu. In dem den beiden Thermoschenkeln A, B benachbarten äußeren Volumenbereich ist ein durch das Wärme dämmende Material 6 gebildetes Isolierelement vorgesehen. Für einen durch das Thermoelement hindurch strömenden Wärmestrom Q steht somit eine an die erste elektrische Kontaktbrücke 1 angrenzende erste Durchtrittsfläche $F_1$ und andererseits eine an die elektrischen Kontaktbrücken 2 angrenzende zweite Durchtrittsfläche F zur Verfügung. Im Bereich der ersten Kontaktbrücke 1 ist somit die erste Durchtrittsfläche $F_1$ durch aus dem Wärme dämmenden Material 6 gebildete Isolierelemente begrenzt. Die Ausdehnung der beiden Thermoschenkel A, B zwischen den beiden elektrischen Kontaktbrücken 1, 2 hat - entsprechend der Darstellung gemäß Fig. 9 - eine Länge 1. Die erste Durchtrittsfläche $F_1$ und die zweite Durchtrittsfläche F, die jeweils ein Ende der Thermoschenkel A, B bilden, sind gleichzeitig auch jene Flächen, die im Bereich der genannten Enden für die Leitung des elektrischen Stroms 7, 7' zur Verfügung stehen. Dabei ist natürlich zu berücksichtigen, dass in den beiden Thermoschenkel A, B die Richtung des elektrischen Stroms 7, 7' (Fig. 2a) entgegengesetzt, die Stromrichtung des Wärmeflusses aber gleichgerichtet ist. Für den Wert der Dichte des elektrischen Stromflusses ist also jeweils etwa die Hälfte der ersten Durchtrittsfläche $F_1$ bzw. der zweiten Durchtrittsfläche F bestimmend.

Für eine näherungsweise Berechnung des Wirkungsgrads des durch die beiden Thermoschenkel A, B gebildeten Thermoelements sei angenommen, dass das skalare Feld der ortsabhängigen Temperatur $T(\bar{r})$ nur von der Längserstreckung entsprechend der Länge 1 abhängt. Entsprechend dem in Fig. 9 angegebenen Koordinatenkreuz, ist also die Temperatur T nur von der Koordinate x abhängig, d.h. T(x). Die bekannte Beziehung der Wärmestromdichte $\bar{q}$, die gleich ist dem Produkt aus dem negativen Wert der Wärmeleitfähigkeit $\lambda$ und dem Gradienten der Temperaturverteilung T(x), geht somit über in eine Gleichung, die nur von der Koordinate x abhängig ist.

$$\bar{q} = -\lambda \cdot \nabla T$$

$$\frac{Q}{F(x)} = -\lambda \cdot \frac{dT(x)}{dx}$$

Weiters sei vorausgesetzt, dass für den gesamten Wärmestrom Q nur das Volumen der beiden Thermoschenkel A, B zur Verfügung steht. Dies ist gleichbedeutend mit den Randbedingungen für die oben angegebene Wärmeleitungsgleichung, dass der gesamte Wärmestrom Q durch die erste Durchtrittsfläche $F_1$ gleich sein muss dem Wärmestrom Q durch die zweite Durchtrittsfläche F. Entsprechend dieser Annahmen ergibt sich somit ein Gesamtwärmestrom Q, der proportional ist der an dem Thermoelement anliegenden Temperaturdifferenz $T_h$ - $T_k$ entsprechend der nachfolgend angegebenen Formel.

$$Q = \frac{2 \cdot \lambda \cdot F}{l} \cdot \frac{1}{1 + \frac{F}{F_1}} \cdot (T_h - T_k)$$

Dabei wurde außerdem für die beiden Thermoschenkel A, B die gleiche Wärmeleitfähigkeit $\lambda$ vorausgesetzt.
Zur Berechnung der dem Thermoelement entnehmbaren elektrischen Leistung P wird ebenfalls in vereinfachter Betrachtungsweise angenommen, dass der spezifische elektrische Widerstand $\rho$ der beiden Thermoschenkel A, B gleich ist. Die elektrische Leistung berechnet sich aus dem Quotienten des Quadrats der Seebeck-Spannung und dem elektrischen Widerstand der elektrisch in Serie geschalteten Thermoschenkel A, B entsprechend der nachstehenden Formel.

$$P = \frac{S^2 \cdot (T_h - T_k)^2}{R}$$

Unter Vorraussetzung einer nur von der Koordinate x abhängigen elektrischen Stromdichte $\bar{j}$ in den Thermoschenkeln A, B ergibt sich ein gesamter elektrischer Widerstand R der in Serie geschalteten Thermoschenkel A, B entsprechend nachstehender Formel.

$$R = \frac{4 \cdot \rho \cdot l}{F} \cdot \frac{\ln \left| \frac{F}{F_1} \right|}{1 - \frac{F_1}{F}}$$

Für den aus dem Quotienten aus der elektrischen Leistung P und dem gesamten Wärmestrom Q sich berechnenden Wirkungsgrad $\eta$ ergibt sich somit die folgende Formel.

$$\eta = \frac{P}{Q} = \frac{S^2}{4 \cdot \rho \cdot \lambda} \cdot (T_h - T_k) \cdot \frac{1}{2} \cdot \frac{\dfrac{F}{F_1} - \dfrac{F_1}{F}}{\ln \left| \dfrac{F}{F_1} \right|}$$

Es ergibt sich somit in überraschender Weise eine Erhöhung des Wirkungsgrades $\eta$ je kleiner die erste Durchtrittsfläche $F_1$ im Verhältnis zu der zweiten Durchtrittsfläche F gewählt wird. Dies erscheint insofern überraschend, als gemäß der vorstehenden Formel für den Wärmestrom Q sich bei Wahl eines kleineren Wertes für die Durchtrittsfläche $F_1$ auch ein entsprechend kleinerer Wert für den Gesamtwärmestrom Q ergibt. Ist andererseits der Wärmestrom Q fest vorgegeben, wie dies bei einer Wärmequelle mit zeitlich konstanter Wärmeleistung der Fall ist, bedeutet dies, dass sich eine höhere Temperaturdifferenz $T_h$-$T_k$ einstellen muss, womit sich - entsprechend der vorstehenden Formel für den Wirkungsgrad $\eta$ - ebenfalls eine Erhöhung des Wirkungsgrads $\eta$ ergibt.

Somit kann bei einer Ausführung eines Thermoelementes mit einer im Verhältnis zur zweiten Durchtrittsfläche F wesentlich kleineren, ersten Durchtrittsfläche $F_1$ die erhaltene elektrische Leistung P im Verhältnis zu dem über die Thermoschenkel A, B durchtretenden Wärmestrom Q deutlich erhöht werden. Mit dieser konstruktiven Maßnahme des Vorsehens einer klein gewählten, ersten Durchtrittsfläche $F_1$ wird im Bereich dieser Durchtrittsfläche $F_1$ sowohl die thermische Stromdichte $\bar{q}$ als auch die elektrische Stromdichte $\bar{j}$ deutlich erhöht.

Bei dem vorstehenden Ausführungsbeispielen gemäß den Fig. 2 bis 9 wurde stets angenommen, dass die elektrischen Kontaktbrücken 2 dem kühlen bzw. niederen Temperaturbereich $T_k$ und die elektrische Kontaktbrücke 1 dem höheren Temperaturniveau $T_h$ zugewandt sind. Alternativ ist es aber auch möglich, eine Anordnung mit der ersten Kontaktbrücke 1 bzw. der ersten Durchschnittsfläche F1, die dem niedrigeren Temperaturniveau $T_k$ zugewandt ist, vorzusehen. Auch für eine solche umgekehrte Anordnung bzw. Ausrichtung der Thermoschenkel A, B kann die vorstehend beschriebene Erhöhung des Wirkungsgrads $\eta$ erreicht werden.

Die Fig. 10 zeigt ein alternatives Ausführungsbeispiel einer Thermoelementenanordnung aus zwei annähernd keilförmigen Thermoschenkeln A, B. Gemäß diesem Ausführungsbeispiel ist die erste Durchtrittsfläche $F_1$ mit einer Wärmebrücke 11 verbunden. Die Wärmebrücke 11 ist vorzugsweise plattenförmig (wie die "Thermozunge" gemäß Fig. 5) ausgebildet, wobei sie mit einer schmalen Stirnseite mit der ersten Durchtrittsfläche $F_1$ thermisch kontaktiert ist und im Wesentlichen parallel zu dem Spalt 4 zwischen den beiden Thermoschenkeln A, B ausgerichtet ist. Beiderseits der Thermoschenkel A, B als auch der Wärmebrücke 11 sind wiederum durch wärmedämmende Materialien 6 gebildete Isolierelemente vorgesehen, sodass für den gesamten Wärmestrom Q nur die Wärmebrücke 11 und - daran anschließend - die beiden Thermoschenkel A, B zum Durchtritt aus dem Bereich der Temperatur $T_h$ zum Bereich der Temperatur $T_k$ zur Verfügung stehen. Im Unterschied zu dem Ausführungsbeispiel gemäß Fig. 9 ist nun die erste Durchtrittsfläche $F_1$ kleiner gewählt und wird durch die Wärmebrücke 11 die sich über eine Länge $l_1$ erstreckt, der Gesamtwärmeverletzung Q weiter auf den Bereich der Durchtrittsfläche $F_1$ konzentriert.

Analog zu den für die Berechnung des Wirkungsgrads $\eta$ beim Ausführungsbeispiel gemäß Fig. 9 getroffenen Annahmen kann auch hier der Wirkungsgrad $\eta$ berechnet werden, wobei jedoch zu berücksichtigen ist, dass entsprechend dem Temperaturabfall entlang der Wärmebrücke 11, die für die Erzeugung der Thermospannung bestimmende Temperaturdifferenz $T_c$ - $T_k$ kleiner ist, als die gesamte zur Verfügung stehende Temperaturdifferenz $T_h$ -$T_k$. $T_c$ steht dabei für die Temperatur an der ersten Durchtrittsfläche $F_1$. Die Wärmebrücke 11 verfüge dabei über eine Wärmeleitfähigkeit $\lambda_1$. So ergibt sich die an dem Thermoelement der beiden Thermoschenkel A, B anliegende Temperaturdifferenz $T_c$ - $T_k$ entsprechend der nachstehenden Formel.

$$T_C - T_k = (T_h - T_k) \cdot \frac{1}{1 + \dfrac{2 \cdot \varepsilon}{1 + \dfrac{F}{F_1}}} \quad \text{mit } \varepsilon = \frac{\lambda \cdot l_1 \cdot F}{\lambda_1 \cdot l \cdot F_1}$$

Demnach gilt für den Wirkungsgrad $\eta$ bei dem Thermogenerator bzw. der Thermoelementenanordnung gemäß Fig. 10 ein Wert entsprechend der nachstehenden Formel.

$$\eta = \frac{S^2}{4 \cdot \rho \cdot \lambda} \cdot (T_h - T_k) \cdot \frac{1}{2} \cdot \frac{\dfrac{F}{F_1} - \dfrac{F_1}{F}}{\ln\left|\dfrac{F}{F_1}\right|} \cdot \frac{1}{1 + \dfrac{2 \cdot \varepsilon}{1 + \dfrac{F}{F_1}}}$$

Durch Wahl einer im Verhältnis zur zweiten Durchtrittsfläche 11 entsprechend kleinen ersten Durchtrittsfläche $F_1$, kann somit ein deutlich erhöhter Wirkungsgrad $\eta$ erreicht werden.

Ein Vergleich des Wirkungsgrads $\eta$ mit dem Wirkungsgrad eines Thermoelements mit über die Länge 1 gleich bleibenden Querschnitt F zeigt, dass bereits ab einem Wert des Verhältnisses der zweiten Durchtrittsfläche F zur ersten Durchtrittsfläche $F_1$ von > 10 mehr als eine Verdoppelung des Wirkungsgrades erreicht werden kann. D.h. wenn der Wert der ersten Durchtrittsfläche $F_1$ für den Wärmestrom Q kleiner ist als 10 % des Werts der zweiten Durchtrittsfläche F. Eine deutlichere Verbesserung des Wirkungsgrads $\eta$ kann erreicht werden für einen Wert der Durchtrittsfläche $F_1$, der gewählt ist aus einem Bereich von gleich oder kleiner 5 % bis 2 % der zweiten Durchtrittsfläche F. Bevorzugt wird der Wert der Durchtrittsfläche $F_1$ gewählt aus einem Bereich, der gleich oder kleiner ist als 2 %, insbesondere gleich oder kleiner ist als 1 %, der zweiten Durchtrittsfläche F. Dabei ist jedoch zu berücksichtigen, dass unter realen Gegebenheiten Anteile des Wärmestroms Q durch nicht gänzlich vermeidbare Wärmeleitung über die Isolierelemente des wärmedämmenden Materials 6 verloren gehen und somit der theoretisch mögliche höhere Wirkungsgrad nicht zur Gänze erreicht werden kann. Es wurde jedoch gefunden, dass bei Wahl eines Verhältnisses aus der spezifischen Wärmeleitfähigkeit der Wärmebrücke 11 zu der spezifischen Wärmeleitfähigkeit des Isolierelements bzw. des wärmedämmenden Materials 6 mit einem Wert, der gleich oder größer als $10^5$ ist, beträchtliche Erhöhungen des Wirkungsgrads $\eta$ erreicht werden können.

Für die Materialien der beiden Thermoschenkel A, B ist vorgesehen, dass diese ausgewählt sind aus einer Gruppe die Metalle, Halbleiter und Mineralien umfasst. Als besonders geeignete Mineralien stehen beispielsweise natürliche oder künstliche Skutterudite zur Verfügung. Als Material für die Wärmebrücke 11 ist vorzugsweise ein sowohl gut thermisch als auch gut elektrisch leitendes Metall vorgesehen. Alternativ zur Verwendung einer wärmedämmenden Materialschicht 6 kann auch vorgesehen sein, dass der die Thermoschenkel A, B und die Wärmebrücke 11 umgebende Raum evakuiert ist und derart Wärmestromverluste weitestgehend unterbunden werden.

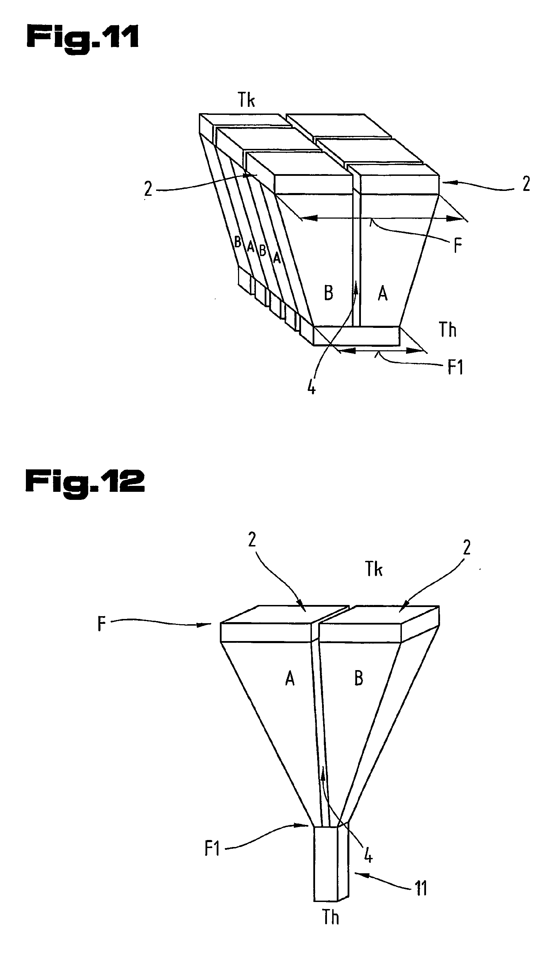

Die Fig. 11 zeigt ein weiteres alternatives Ausführungsbeispiel eines Thermogenerators bzw. einer Thermoelementenanordnung, die in Dünnschichttechnik ausgeführt ist. Thermoschenkel A, B wechseln einander ab und sind über elektrische Kontaktbrücken 1, 2 in Serie geschalten. Entsprechend der trapezförmigen Gestaltung der einzelnen Thermoschenkel A, B wird auch bei diesem Beispiel eine Erhöhung des Wirkungsgrades wie vorstehend bei der Beschreibung des Ausführungsbeispiels gemäß Fig. 9 angegeben, erreicht. Entsprechend der bei dieser Thermoelementenanordnung elektrisch in Serie geschalteten Folge von Thermoschenkeln A, B, A, B, ... steht ein entsprechendes Vielfaches der Seebeck-Spannung eines einzelnen Paars von Thermoschenkeln A, B zur Verfügung. Aus Gründen der besseren Übersichtlichkeit wurde in Fig. 11 auf die Darstellung der Isolierelemente verzichtet, auch ist die Dicke der Schichten der Thermoschenkel A, B unmaßstäblich größer dargestellt.

Die Fig. 12 zeigt ein weiteres Ausführungsbeispiel einer Thermoelementenanordnung mit einem pyramidenförmig ausgebildeten Paar von Thermoschenkeln A, B. Die beiden Thermoschenkel A, B sind dabei jeweils in Form eines schrägen Pyramidenstumpfs gestaltet. Durch einen dünnen Spalt 4 voneinander getrennt, bildet das Paar der Thermoschenkeln A, B so einen gleichseitigen Pyramidenstumpf mit der ersten Durchtrittsfläche $F_1$ und der zweiten Durchtrittsfläche F für den Wärmestrom Q als Deck- bzw. Grundfläche des Pyramidenstumpfs.

Alternativ zu den ebenen bzw. zylinderförmigen Seitenflächen (Fig. 6 bis Fig. 8) der Thermoschenkel A, B können auch verschiedene andere Formen dafür vorgesehen sein. So kann auch ein Querschnitt der Thermoschenkel A, B bezüglich einer die erste Durchtrittsfläche $F_1$ und die zweite Durchtrittsfläche F schneidenden Ebene vorgesehen sein, der eine parabolische oder eine elliptische und konvexe Begrenzung aufweist. Alternativ kann die äußere Begrenzung des Thermoschenkel-Paars A, B auch konkav anstatt konvex gekrümmt sein.

Die Ausführungsbeispiele zeigen mögliche Ausführungsvarianten des Thermogenerators bzw. der Thermoelementenanordnung, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mit umfasst.

Der Ordnung halber sei abschließend darauf hingewiesen, dass zum besseren Verständnis des Aufbaus des Thermogenerators bzw. der Thermoelementenanordnung diese bzw. deren Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

Vor allem können die einzelnen in den Figuren gezeigten Ausführungen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

**Bezugszeichenaufstellung**

| | |
|---|---|
| 1 | Kontaktbrücke |
| 2 | Kontaktbrücke |
| 3 | Querschnittsfläche |
| 4 | Spalt |
| 5 | Bodenfläche |
| 5' | Grundfläche des Volumenäquivalenten Quader |

| | |
|---|---|
| 6 | Wärmedämmende Materialschicht |
| 7 | elektrischer Strom |
| 7' | elektrischer Strom |
| 8 | Senke |
| 9 | Wärmezuführung |
| 10 | Festkörper |

| | |
|---|---|
| 11 | Wärmebrücke / "Thermozunge" |
| 12 | Thermofuß |
| 13 | Volumen-äquivalenter Quader |
| 14 | Wand |
| 15 | Zwischenschicht |

| | |
|---|---|
| 16 | Rohr |
| 17 | elektrisch isolierende Hülle |
| 18 | Kühlkörper |
| 19 | Schacht |
| 20 | Wärme tragende Substanz |

| | |
|---|---|
| 21 | Thermoelement |
| 22 | Position |
| 23 | Wärme tragende Substanz |
| 24 | |
| 25 | |

| | |
|---|---|
| A | Thermoschenkel |
| B | Thermoschenkel |
| $F_1$ | erste Durchtrittsfläche |
| F | zweite Durchtrittsfläche |
| l | Länge der Thermoschenkel |
| $l_1$ | Länge der Wärmebrücke |

**Patentansprüche**

1. Verfahren zur Umwandlung von Wärme in Elektrische Energie vermittels des Thermoelektrischen Effektes, wobei mindestens zwei, bevorzugt aber eine Mehrzahl von Thermoelementen die jeweils mindestens aus zwei unterschiedlichen, den Seebeck-Effekt hervorrufenden, als Thermoschenkel (A, B) bezeichneten Materialien bestehen, in Serien- oder Parallelschaltung oder einer Kombination beider Schaltungen miteinander verbunden sind und wobei die Thermoelemente jeweils über eine zu erwärmende Kontaktstelle verfügen **dadurch gekennzeichnet, dass** folgende Verfahrensschritte angewendet werden:

a) Die zu erwärmende Kontaktstelle weist gegenüber den Thermoschenkeln eine Kontakt-Fläche auf, die kleiner ist als 5% des "Gemittelten Gesamt-Leitungsquerschnittes " welcher sich aus der Beziehung ergibt

$$\varpi = \frac{V_A}{1_A} + \frac{V_B}{1_B}$$

wobei bezeichnen:

$\overline{\omega}$ = Gemittelter Gesamt - Leitungsquerschnitt beider Thermoschenkel
$V_A$ = Volumen des Thermoschenkels A
$V_B$ = Volumen des Thermoschenkels B
$1_A$ = leitende Länge des Thermoschenkels A
$1_B$ = leitende Länge des Thermoschenkels B

b) die von außen zuzuführende Wärmeenergie wird direkt nur an die Kontaktstellen bzw. den von den Kontaktstellen ausgebildeten Kontaktflächen zugeleitet;
c) die von außen zuzuführende Wärmeenergie wird den Kontaktstellen bzw. den von den Kontaktstellen ausgebildeten Kontaktflächen nur in jener limitierten Menge zugeführt, die dem Energieäquivalent der vom jeweiligen Thermoelement erzeugten elektrischen Leistung, zuzüglich der durch Wärmeableitung in die angrenzenden Thermoschenkel (A, B) entstehenden Verluste entspricht.

2. Verfahren nach Anspruch 1, **dadurch gekennzeichnet, dass** ein Isolierelement angeordnet wird, durch das eine erste Durchtrittsfläche ($F_1$) des Thermoelements für den Wärmestrom (Q) und für den elektrischen Strom (7, 7') seitlich, d.h. an dem Umfang der ersten Durchtrittsfläche ($F_1$), begrenzt wird.

3. Verfahren nach Anspruch 2, **dadurch gekennzeichnet, dass** das Isolierelement durch eine Wärmedämmende Materialschicht (6) gebildet wird.

4. Verfahren nach einem der vorhergehenden Ansprüche, **dadurch gekennzeichnet, dass** die erste Durchtrittsfläche ($F_1$) durch eine Oberfläche einer die beiden Thermoschenkel (A, B) elektrisch verbindenden ersten Kontaktbrücke (1) gebildet wird.

5. Verfahren nach einem der Ansprüche 1 bis 3, **dadurch gekennzeichnet, dass** die erste Durchtrittsfläche ($F_1$) mit einer Wärmebrücke (11) verbunden wird, wobei das Verhältnis aus der spezifischen Wärmeleitfähigkeit der Wärmebrücke (11) und der spezifischen Wärmeleitfähigkeit des Isolierelements einen Wert hat der größer ist als $10^5$.

6. Verfahren nach einem der vorhergehenden Ansprüche, **dadurch gekennzeichnet, dass** ein Querschnitt der Thermoschenkel (A, B) bezüglich einer die erste Durchtrittsfläche ($F_1$) und eine zweite Durchtrittsfläche (F) für den Wärmestrom (Q) und für den elektrischen Strom (7, 7') schneidenden Ebene mit einer zumindest annähernd kreisbogenförmigen und konvexen Begrenzung ausgebildet wird.

7. Verfahren nach einem der Ansprüche 1 bis 5, **dadurch gekennzeichnet, dass** ein Querschnitt der Thermoschenkel (A, B) bezüglich einer die erste Durchtrittsfläche ($F_1$) und die zweite Durchtrittsfläche (F) schneidenden Ebene trapezförmig ausgebildet wird.

8. Verfahren nach Anspruch 7, **dadurch gekennzeichnet, dass** die Thermoschenkel (A, B) in Form eines Pyramidenstumpfs ausgebildet werden, wobei die erste Durchtrittsfläche (F1) und die zweite Durchtrittsfläche (F) Grundbzw. Deckfläche des Pyramidenstumpfs bilden.

9. Verfahren nach einem der Ansprüche 5 bis 8, **dadurch gekennzeichnet, dass** die Wärmebrücke (11) plattenförmig (in Form einer "Thermozunge") ausgebildet wird und mit einer schmalen Stirnseite mit der ersten Durchtrittsfläche ($F_1$) verbunden wird.

**10.** Verfahren nach einem der vorhergehenden Ansprüche, **dadurch gekennzeichnet, dass** zumindest ein Material der Thermoschenkel (A, B) aus einer Gruppe, umfassend Metalle, Halbleiter und Minerale, ausgewählt wird.

**11.** Verfahren nach Anspruch 10, **dadurch gekennzeichnet, dass** zumindest ein Material der Thermoschenkel (A, B) aus einer Gruppe, umfassend natürliche oder künstliche Skutterudite, ausgewählt wird.

**12.** Verfahren nach einem der vorhergehenden Ansprüche, **dadurch gekennzeichnet, dass** die Thermoschenkel (A, B) in Dünnschicht-Technik ausgeführt werden.

**13.** Verfahren nach einem der vorhergehenden Ansprüche, **dadurch gekennzeichnet, dass** die Dimensionierung der Thermoschenkel (A, B) nach dem Prinzip der Querschnitts-Optimierung für geringsten elektrischen Serienwiderstand ausgelegt wird.

**14.** Verfahren nach einem der Ansprüche 1 bis 12, **dadurch gekennzeichnet, dass** die Dimensionierung der Thermoschenkel (A, B) nach dem Prinzip der Querschnitts-Optimierung für höchsten thermischen Parallelwiderstand ausgelegt wird.

**Claims**

**1.** A method for converting heat into electrical energy by means of the thermoelectric effect, wherein at least two thermoelements, preferably a plurality thereof, which respectively consist of at least two different materials that cause the Seebeck-Effect and are designated as thermoelement legs (A, B), are connected in a series or parallel connection or a combination of both connections, and wherein the thermoelements respectively comprise a contact point to be heated, **characterized in that** the following method steps will be applied:

a) the contact point to be heated has a contact area in comparison with the thermoelement legs which is smaller than 5% of the "averaged total line cross section", which is obtained from the relation

$$\varpi = \frac{V_A}{1_A} + \frac{V_B}{1_B},$$

wherein:

$\overline{\omega}$ = averaged total line cross section of both thermoelement legs
$V_A$ = volume of thermoelement leg A
$V_B$ = volume of thermoelement leg B
$1_A$ = conducting length of thermoelement leg A
$1_B$ = conducting length of thermoelement leg B

b) the thermal energy to be supplied from the outside will be fed directly only to the contact points or the contact areas formed by the contact points;
c) the thermal energy to be supplied from the outside will be fed to the contact points or the contact areas formed by the contact points only in such limited quantity which corresponds to the energy equivalent of the electrical power generated by the respective thermoelement, plus the losses originating from heat dissipation into the adjacent thermoelement legs (A, B).

**2.** A method according to claim 1, **characterized in that** an insulating element is arranged, by means of which a first transfer area ($F_1$) of the thermoelement for the heat flow (Q) and for the electrical current (7, 7') is delimited laterally, i.e. on the circumference of the first transfer area ($F_1$).

**3.** A method according to claim 2, **characterized in that** the insulating element is formed by a heat-insulating material layer (6).

**4.** A method according to one of the preceding claims, **characterized in that** the first transfer area ($F_1$) is formed by a surface of a first contact bridge (1) electrically connecting the two thermoelement legs (A, B).

5. A method according to one of the claims 1 to 3, **characterized in that** the first transfer area ($F_1$) is connected with a thermal bridge (11), wherein the ratio of the specific thermal conductivity of the thermal bridge (11) and the specific thermal conductivity of the insulating element of the insulating element has a value which is larger than $10^5$.

6. A method according to one of the preceding claims, **characterized in that** a cross section of the thermoelement legs (A, B) is formed with respect to a plane intersecting the first transfer area ($F_1$) and a second transfer area (F) for the heat flow (Q) and for the electric current (7, 7') with an at least approximately arc-shaped and convex boundary.

7. A method according to one of the claims 1 to 5, **characterized in that** a cross section of the thermoelement legs (A, B) is arranged in a trapezoidal manner with respect to a plane intersecting the first transfer area ($F_1$) and the second transfer area (F).

8. A method according to claim 7, **characterized in that** the thermoelement legs (A, B) are arranged in form of a truncated pyramid, wherein the first transfer area ($F_1$) and the second transfer area (F) form the base and cover area of the truncated pyramid.

9. A method according to one of the claims 5 to 8, **characterized in that** the thermal bridge (11) is formed in a plate-like manner (in form of a "thermal tongue") and is connected with a narrow face side with the first transfer area ($F_1$).

10. A method according to one of the preceding claims, **characterized in that** at least one material of the thermoelement legs (A, B) is chosen from a group comprising metals, semiconductors and minerals.

11. A method according to claim 10, **characterized in that** at least one material of the thermoelement legs (A, B) is chosen from a group comprising natural or synthetic skutterudites.

12. A method according to one of the preceding claims, **characterized in that** the thermoelement legs (A, B) are formed in thin-film technology.

13. A method according to one of the preceding claims, **characterized in that** the dimensioning of the thermoelement legs (A, B) is formed according to the principle of cross-section optimization for the lowest electrical series resistance.

14. A method according to one of the claims 1 to 12, **characterized in that** the dimensioning of the thermoelement legs (A, B) is formed according to the principle of cross-section optimization for the highest thermal parallel resistance.

**Revendications**

1. Procédé pour convertir de la chaleur en énergie électrique au moyen de l'effet thermoélectrique, dans lequel au moins deux, mais de préférence plusieurs thermocouples composés chacun au moins de deux matériaux différents provoquant l'effet Seebeck et appelés bras de thermocouple (A, B) sont reliés entre eux dans un montage en série ou en parallèle ou une combinaison des deux montages et dans lequel les thermocouples disposent chacun d'un point de contact à échauffer, **caractérisé en ce que** les étapes de procédé suivantes sont utilisées:

   a) le point de contact à échauffer présente par rapport aux bras de thermocouple une surface de contact inférieure à 5 % de la «section de ligne totale moyenne» qui est donnée par la relation

$$\varpi = \frac{V_A}{l_A} + \frac{V_B}{l_B}$$

   où:

   $\overline{\omega}$ = section de ligne totale moyenne des deux bras de thermocouple
   $V_A$ = volume du bras de thermocouple A
   $V_B$ = volume du bras de thermocouple B
   $1_A$ = longueur conductrice du bras de thermocouple A
   $1_B$ = longueur conductrice du bras de thermocouple B

b) l'énergie thermique amenée de l'extérieur est amenée directement et seulement aux pointes de contact ou aux surfaces de contact formées par les points de contact;

c) l'énergie thermique amenée de l'extérieur n'est amenée aux points de contact ou aux surfaces de contact formées par les points de contact qu'en une quantité limitée correspondant à la puissance électrique produite par le thermocouple correspondant, plus les pertes qui se produisent du fait de l'évacuation de la chaleur dans les bras de thermocouple (A, B) limitrophes.

2. Procédé selon la revendication 1, **caractérisé en ce qu'**il est prévu un élément isolant par lequel une première surface de passage ($F_1$) du thermocouple pour le flux thermique (Q) et pour le courant électrique (7, 7') est délimitée latéralement, c'est-à-dire sur la circonférence de la surface de passage ($F_1$).

3. Procédé selon la revendication 2, **caractérisé en ce que** l'élément isolant est formé par une couche de matériau (6) réalisant une isolation thermique.

4. Procédé selon l'une des revendications précédentes, **caractérisé en ce que** la première surface de passage ($F_1$) est formée par une surface d'un premier pont de contact (1) reliant électriquement les deux bras de thermocouple (A, B).

5. Procédé selon l'une des revendications 1 à 3, **caractérisé en ce que** la première surface de passage ($F_1$) est reliée à un pont thermique (11), le rapport entre la conductibilité thermique spécifique du pont thermique (11) et la conductibilité thermique spécifique de l'élément isolant ayant une valeur supérieure à $10^5$.

6. Procédé selon l'une des revendications précédentes, **caractérisé en ce qu'**une section des bras de thermocouple (A, B) par rapport à un plan coupant la première surface de passage ($F_1$) et une deuxième surface de passage (F) pour le flux thermique (Q) et pour le courant électrique (7, 7') est conformée avec une délimitation au moins approximativement en arc de cercle et convexe.

7. Procédé selon l'une des revendications 1 à 5, **caractérisé en ce qu'**une section des bras de thermocouple (A, B) par rapport à un plan coupant la première surface de passage ($F_1$) et la deuxième surface de passage (F) a une forme trapézoïdale.

8. Procédé selon la revendication 7, **caractérisé en ce que** les bras de thermocouple (A, B) sont conformés en forme de pyramide tronquée, la première surface de passage ($F_1$) et la deuxième surface de passage (F) formant la surface de base et la surface de sommet de la pyramide tronquée.

9. Procédé selon l'une des revendications 5 à 8, **caractérisé en ce que** le pont thermique (11) est conçu en forme de plaque (sous la forme d'une «languette thermique») et relié par une face d'extrémité étroite à la première surface de passage ($F_1$).

10. Procédé selon l'une des revendications précédentes, **caractérisé en ce qu'**au moins un matériau des bras de thermocouple (A, B) est choisi dans un groupe comprenant des métaux, des semi-conducteurs et des minéraux.

11. Procédé selon la revendication 10, **caractérisé en ce qu'**au moins un matériau des bras de thermocouple (A, B) est choisi dans un groupe comprenant des skutterudites naturelles ou synthétiques.

12. Procédé selon l'une des revendications précédentes, **caractérisé en ce que** les bras de thermocouple (A, B) sont réalisés selon une technique de couche mince.

13. Procédé selon l'une des revendications précédentes, **caractérisé en ce que** le dimensionnement des bras de thermocouple (A, B) est réalisé selon le principe d'optimisation de la section pour obtenir la résistance en série électrique la plus faible.

14. Procédé selon l'une des revendications 1 à 12, **caractérisé en ce que** le dimensionnement des bras de thermocouple (A, B) est réalisé selon le principe d'optimisation de la section pour obtenir la résistance thermique en parallèle la plus élevée.

## Fig.1a

## Fig.1b

## Fig.1c

**Fig.2a**

**Tk**

2

A

4

B

7

7'

3

**Th**

1

**Fig.2b**

A

B

3

1

5

2

**Fig.2c**

**Tk**

2

A

4

B

7

7'

3

3

6

6

9

**Th**

9

1

**Fig.2d**

1

6

6

8

**Fig.3a**

**Fig.3b**

**Fig.3c**

**Fig.3d**

## Fig.4

## Fig.5

**Fig.6a**

**Fig.6b**

**Fig.6c**

# Fig.7

# Fig.8

**Fig.9**

**Fig.10**

# Fig.11

# Fig.12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 03155376 B